# EUROPEAN PATENT SPECIFICATION

(11) **EP 2 445 023 B1**
(45) Date of publication and mention of the grant of the patent: **13.05.2020**
(21) Application number: 11165468.7
(22) Date of filing: 10.05.2011
(51) Int. Cl.: H01L 33/58, G02B 19/00, G09F 19/18, H01L 25/075, H01L 33/48

(54) **Light emitting diode stereoscopic display device**
Stereoskopische LED-Anzeigevorrichtung
Dispositif d'affichage stéréoscopique à diodes électroluminescentes

(30) Priority: 20.10.2010 TW 099135829
(43) Date of publication of application: 25.04.2012
(73) Proprietor: Macroblock, Inc., Hsinchu City (TW)
(72) Inventor: Yang, Li-Chang, Hsinchu City (TW); Wu, Chung-Yu, Hsinchu City (TW); CAI, Zong-Huan, Hsinchu City (TW)
(74) Representative: Viering, Jentschura & Partner mbB Patent- und Rechtsanwälte

(56) References cited:
- US-A1- 2006 120 085
- US-A1- 2006 158 729
- US-A1- 2007 176 187

## Description

### BACKGROUND OF THE INVENTION

### Field of the Invention

The present invention relates to a Light Emitting Diode (LED) packaging structure and an LED stereoscopic display device, and more particularly to an LED packaging structure and an LED stereoscopic display devices having a plurality of viewable areas.

### Related Art

Recently, a stereoscopic display device has two methods for displaying a stereoscopic image. In one method, a viewer needs to wear a pair of specially treated glasses to view the display device, so that images received by a left eye and a right eye are different, or images of the left eye and the right eye are staggered to generate the stereoscopic image. In the method, the viewer needs to additionally wear the glasses to view the stereoscopic image, so that the method is not convenient in using.

In the other method, a naked eye display device is used. A grating principle is used in the display device, so that the viewer needs not to wear any additional device, and the images viewed by the left eye and the right eye are different, thereby generating the stereoscopic image. Recently, the method is applied to printed products, baseball cards, or a part of naked eye electronic stereoscopic displays. For example, an LED stereoscopic display device disclosed in US Patent Application No. 20090237914 comprises a substrate, a plurality of pixels, and a cylindrical lens array. The plurality of pixels is disposed on the substrate, and each of the plurality of pixels comprises a plurality of different color LEDs; the plurality of pixels forms a plurality of odd-line pixel areas and a plurality of even-line pixel areas alternately arranged along a first direction; the cylindrical lens array is disposed relative to the substrate and is adjacent to the plurality of pixels, and comprises a plurality of cylindrical lenses arranged along the first direction, each of the plurality of cylindrical lenses comprises a cylindrical surface being far away from the plurality of pixels, and each of the plurality of cylindrical lenses corresponds to one odd-line pixel area and one even-line pixel area adjacent to the odd-line pixel area.

Although through the LED stereoscopic display device, the viewer may view the stereoscopic image without wearing the glasses, a problem of a single viewable area exists. In the LED stereoscopic display device, the cylindrical lens array having a large area is required to correspond to the odd-line pixel areas and the even-line pixel area, and when being manufactured, the cylindrical lens array having the large area is easily deformed during press molding or is deformed due to a thermal stress generated during cooling, so that the manufacture is difficult. Further, Since refraction indices of lights having different wavelengths in the same material are different, when the LED dies emitting different color lights in the same pixel are packaged in the same cylindrical lens array, refraction angles generated by the different color lights after passing through the same cylindrical lens array are different, so that when the viewer views the LED stereoscopic display device at a far distance, quality of the stereoscopic image is lowered.

US 2006//120085 A1 discloses a further known device.

US 2006/158729 A1 discloses a stereoscopic display having a plurality of viewable areas.

### SUMMARY OF THE INVENTION

In view of above problems, the present invention is a LED stereoscopic display device, capable of solving the problems of a conventional LED stereoscopic display device that only a single viewable area exists, a manufacturing process is difficult, and quality of an image is changed when a viewing distance between eyes of a viewer and the LED stereoscopic display device is changed.

In an embodiment of the LED packaging structure, the LED packaging structure comprises a first LED die, a second LED die, a package body, and an optical element. The package body is used to wrap the first LED die and the second LED die. The optical element is disposed on the package body. The first LED die emits a first light beam, and the second LED die emits a second light beam. The first light beam passes through the optical element and then is split into a plurality of first sub-light beams, and each of the plurality of first sub-light beams is individually projected onto a first image plane corresponding to each of the plurality of first sub-light beams. The second light beam passes through the optical element and then is split into a plurality of second sub-light beams, and each of the plurality of second sub-light beams is individually projected onto a second image plane corresponding to each of the plurality of second sub-light beams. The first image planes and the second image planes are alternately arranged.

In an embodiment of the LED packaging structure, the LED packaging structure comprises at least one light emitting unit, a package body, and an optical element. The light emitting unit comprises a first LED die and a second LED die, and the first LED die and the second LED die are arranged in sequence along a direction. The package body is used to wrap the light emitting unit, and the optical element is disposed on the package body. The first LED die emits a first light beam, and the second LED die emits a second light beam. The first light beam and the second light beam respectively pass through a part of the optical element and are projected onto an image plane, and a position of the first light beam projected onto the image plane is disposed on one side of a position of the second light beam projected onto the image plane.

In an embodiment of the LED stereoscopic display device according to the present invention, the LED stereoscopic display device has a plurality of viewable areas, and the LED stereoscopic display device comprises a substrate, a plurality of first pixel areas, and a plurality of second pixel areas. The plurality of first pixel areas and the plurality of second pixel areas are disposed on the substrate, and are alternately arranged along a direction. Each of the plurality of first pixel areas comprises a plurality of first pixel units, each of the plurality of first pixel units comprises a plurality of first LED packaging structures, and each of the plurality of first LED packaging structures comprises a first LED die, a first package body, and a first optical element. The first package body is used to wrap the first LED die, and the first optical element is disposed on the first package body. The first LED die emits a first light beam, the first light beam passes through the first optical element and then is split into a plurality of first sub-light beams, and each of the plurality of first sub-light beams is individually projected onto a first image plane corresponding to each of the plurality of first sub-light beams.

Each of the plurality of second pixel areas comprises a plurality of second pixel units, each of the plurality of second pixel units comprises a plurality of second LED packaging structures, and each of the plurality of second LED packaging structures corresponds to each of the plurality of first LED packaging structures. Each of the plurality of second LED packaging structures comprises a second LED die, a second package body, and a second optical element. The second package body is used to wrap the second LED die, and the second optical element is disposed on the second package body. The second LED die emits a second light beam, the second light beam passes through the second optical element and then is split into a plurality of second sub-light beams, and each of the plurality of second sub-light beams is individually projected onto a second image plane corresponding to each of the plurality of second sub-light beams. Each of the plurality of second image planes corresponds to each of the plurality of first image planes, and an adjacent area of each second image plane and each first image plane corresponding to each second image plane forms the viewable area.

In an embodiment of the LED stereoscopic display device according to the present invention, the LED stereoscopic display device has a plurality of viewable areas, and the LED stereoscopic display device comprises a substrate and a plurality of pixel areas. The plurality of pixel areas is disposed on the substrate, and each of the plurality of pixel areas comprises a plurality of LED packaging structures. Each of the plurality of LED packaging structures comprises a first LED die, a second LED die, a package body, and an optical element. The package body is used to wrap the first LED die and the second LED die, and the optical element is disposed on the package body. The first LED die emits a first light beam, the first light beam passes through the optical element and then is split into a plurality of first sub-light beams, and each of the plurality of first sub-light beams is individually projected onto a first image plane corresponding to each of the plurality of first sub-light beams. The second LED die emits a second light beam, the second light beam passes through the optical element and then is split into a plurality of second sub-light beams, and each of the plurality of second sub-light beams is individually projected onto a second image plane corresponding to each of the plurality of second sub-light beams. Each second image plane corresponds to each first image plane, and an adjacent area of each second image plane and each first image plane corresponding to each each second image plane forms the viewable area.

In an embodiment of the LED stereoscopic display device according to the present invention, the LED stereoscopic display device comprises a substrate and a plurality of LED packaging structures. The plurality of LED packaging structures is disposed on the substrate, and each LED packaging structure comprises at least one light emitting unit, a package body, and an optical element. The light emitting unit comprises a first LED die and a second LED die, and the first LED die and the second LED die are arranged in sequence along a direction. The package body is used to wrap the light emitting unit, and the optical element is disposed on the package body. The first LED die emits a first light beam, the second LED die emits a second light beam, and the first light beam corresponds to the second light beam. The first light beam and the second light beam respectively pass through a part of the optical element and are projected onto an image plane, and an adjacent area of a position of the first light beam projected onto the image plane and a position of the second light beam projected onto the image plane forms a viewable area.

In the LED packaging structure, the amount of the image planes may be controlled by the design of the optical element, thereby achieving a multi-viewing angle objective. Next, the positions of the image planes are controlled by a refraction index of the package body and the design of the optical element, wherein the refraction index of the package body is affected by a wavelength of the light beam. Further, distribution of the positions of the image planes may also be affected by a distance between the LED die and the central axis and a relative position of the LED die and the central axis.

In the LED stereoscopic display device according to the present invention, through the design of the LED packaging structures and since the LED packaging structures are disposed on different positions of the substrate, the LED stereoscopic display device may perform imaging at a plurality of viewing angles, wherein the design of the optical element may affect the amount of the viewable areas. Therefore, each LED packaging structure is adjusted according to actual demands, so that the quality of the stereoscopic image viewed by the eyes of the viewer is improved.

Further, in the LED stereoscopic display device according to the present invention, the larger the amount of the light emitting units of the LED packaging structure is, the larger the amount of the viewable areas is. Further, the positions of the viewable areas may be adjusted by the refraction index of the package body and the design of the optical elements, so that the viewable areas formed by the light emitting units are staggered, so the images shown by the different viewable areas are different, wherein the wavelengths of the first light beam and the second light beam affect the refraction index of the package body.

### BRIEF DESCRIPTION OF THE DRAWINGS

The present invention will become more fully understood from the detailed description given herein below for illustration only, and thus are not limitative of the present invention, and wherein:
FIG. 1A is a schematic top structural view of a first embodiment of an LED packaging structure;
FIG. 1B is a schematic cross-sectional structural view according to Line 1B-1B of FIG. 1A;
FIG. 1C is a schematic view of light beam trace according to FIG. 1B;
FIG. 2A is a schematic cross-sectional structural view of a second embodiment of an LED packaging
   structure;
FIG. 2B is a schematic view of light beam trace according to FIG. 2A;
FIG. 3A is a schematic cross-sectional structural view of a third embodiment of an LED packaging
   structure;
FIG. 3B is a schematic view of light beam trace according to FIG. 3A;
FIG. 4A is a schematic cross-sectional structural view of a fourth embodiment of an LED packaging
   structure;
FIG. 4B is a schematic view of light beam trace according to FIG. 4A;
FIG. 5 is a schematic structural view of a first embodiment of an LED stereoscopic display device according to the present invention;
FIG. 6 is a schematic cross-sectional structural view of a second LED packaging structure and a first LED packaging structure corresponding to the second LED packaging structure according to FIG. 5;
FIG. 7 is a schematic view of light beam trace according to FIG. 6;
FIG. 8 is a schematic view of light beam trace of an embodiment wherein the LED packaging structures of FIGs. 2A, 3A, and 4A are disposed on different positions of the same substrate respectively;
FIG. 9 is a schematic view of light beam trace of another embodiment wherein the LED packaging structures of FIGs. 2A, 3A, and 4A are disposed on different positions of the same substrate respectively;
FIG. 10A is a schematic top structural view of a fifth embodiment of an LED packaging
   structure;
FIG. 10B is a schematic cross-sectional structural view according to Line 10B-10B of FIG. 10A;
FIG. 10C is a schematic view of light beam trace according to FIG. 10B;
FIG. 11 is a schematic structural view of an embodiment in which the LED packaging structure according to FIG. 10B is applied to an LED stereoscopic display
   device which is not part of the invention;
FIG. 12A is a schematic top structural view of a design of an LED packaging structure, wherein said figure does not show all features of the present invention;
FIG. 12B is a schematic cross-sectional structural view according to Line 12B-12B of FIG. 12A;
FIG. 12C is a schematic view of light beam trace according to FIG. 12B;
FIG. 13 is a schematic structural view of an embodiment in which the LED packaging structure according to FIG. 12B is applied to an LED stereoscopic display
   device which is not part of the invention;
FIG. 14A is a schematic top structural view of a sixth embodiment of an LED packaging
   structure;
FIG. 14B is a schematic cross-sectional structural view according to Line 14B-14B of FIG. 14A;
FIG. 14C is a schematic view of light beam trace according to FIG. 14B;
FIG. 15 is a schematic structural view of a second embodiment of an LED stereoscopic display device according to the present invention;
FIG. 16 is a schematic cross-sectional structural view of a second LED packaging structure and a first LED packaging structure corresponding to the second LED packaging structure according to FIG. 15;
FIG. 17 is a schematic view of light beam trace according to FIG. 16;
FIG. 18A is a schematic top structural view of a seventh embodiment of an LED packaging
   structure;
FIG. 18B is a schematic cross-sectional structural view according to Line 18B-18B of FIG. 18A;
FIG. 18C is a schematic view of light beam trace according to FIG. 18B;
FIG. 19 is a schematic structural view of an embodiment in which the LED packaging structure according to FIG. 18B is applied to an LED stereoscopic display
   device which is not part of the invention;
FIG. 20A is a schematic top structural view of a eighth embodiment of an LED packaging structure,
FIG. 20B is a schematic cross-sectional structural view according to Line 20B-20B of FIG. 20A;
FIG. 20C is a schematic view of light beam trace according to FIG. 20B; and
FIG. 21 is a schematic structural view of an embodiment in which the LED packaging structure according to FIG. 20B is applied to an LED stereoscopic display
   device which is not part of the invention.

### DETAILED DESCRIPTION OF THE INVENTION

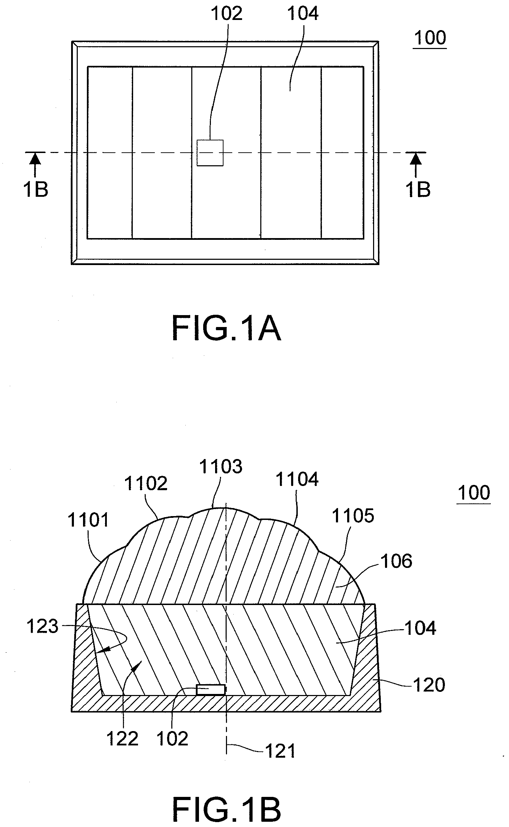

FIG. 1A is a schematic top structural view of a first embodiment of an LED packaging structure, and FIG. 1B is a schematic cross-sectional structural view according to Line 1B-1B of FIG. 1A. Referring to FIGs. 1A and 1B, the LED packaging structure 100 comprises an LED die 102, a package body 104, and an optical element. The optical element is a lens 106, the lens 106 is disposed on the package body 104, and comprises a plurality of curved surfaces 1101, 1102, 1103, 1104, and 1105. The package body 104 is used to wrap the LED die 102.

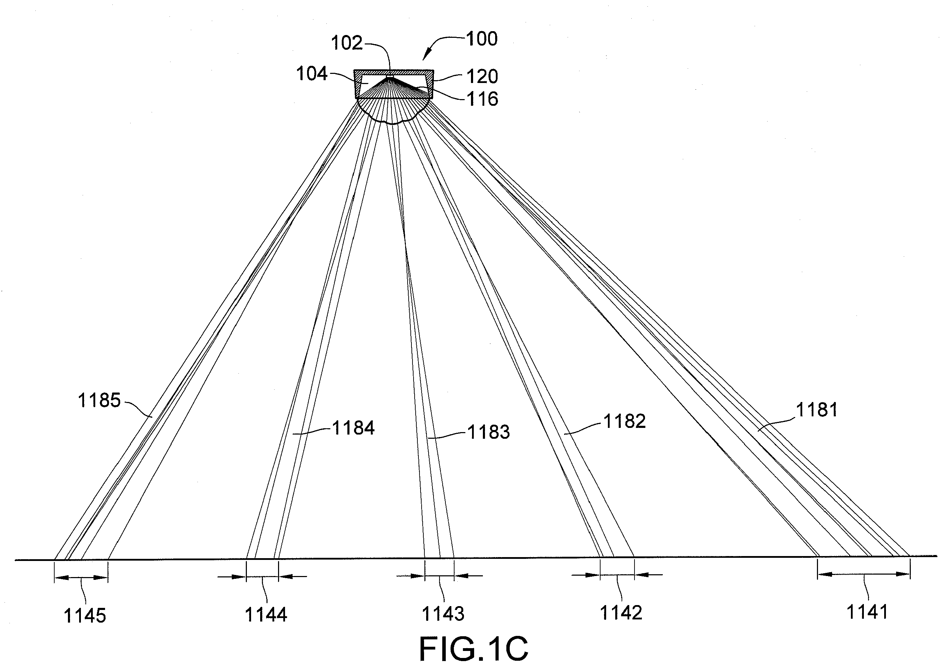

FIG. 1C is a schematic view of light beam trace according to FIG. 1B. Referring to FIG. 1C, each curved surface 1101, 1102, 1103, 1104, and 1105 respectively has a image plane 1141, 1142, 1143, 1144, and 1145 which corresponds to each curved surface 1101, 1102, 1103, 1104, and 1105. In this embodiment, the amount of the curved surfaces is five, and the amount of the image planes is also five, but this embodiment is not used to limit the present invention. That is to say, when the amount of the curved surfaces is six, the amount of the image planes is also six. More specifically, the larger the amount of the curved surfaces is, the larger the amount of the image planes is. FIG. 1C is the schematic view of light beam trace according to FIG. 1B, so that each image plane 1141, 1142, 1143, 1144, and 1145 is a line segment in FIG. 1C. In this embodiment, each image plane 1141, 1142, 1143, 1144, and 1145 may be disposed on the same plane, but this embodiment is not used to limit the present invention.

The LED die 102 emits a light beam 116, the light beam 116 emitted by the LED die 102 passes through the plurality of curved surfaces 1101, 1102, 1103, 1104, and 1105 and then is split into a plurality of sub-light beams 1181, 1182, 1183, 1184, and 1185, and the plurality of sub-light beams 1181, 1182, 1183, 1184, and 1185 is projected onto the image planes 1141, 1142, 1143, 1144, and 1145 which correspond to the plurality of sub-light beams 1181, 1182, 1183, 1184, and 1185. The amount of the sub-light beams is the same as the amount of the curved surfaces. In this embodiment, the package body 104 and the lens 106 each have its own refraction index (not shown), each of the curved surfaces 1101, 1102, 1103, 1104, and 1105 respectively has a curvature radius (not shown), and positions of the image planes 1141, 1142, 1143, 1144, and 1145 are decided according to the refraction index of the package body 104, the refraction index of the lens 106, and the curvature radiuses of the curved surfaces 1101, 1102, 1103, 1104, and 1105. The refraction indices of the package body 104 and the lens 106 are affected by a wavelength of the light beam 116.

Referring to FIG. 1B, the LED packaging structure 100 further comprises a base 120, and the base 120 comprises a central axis 121 and an accommodation space 122. The LED die 102 is disposed in the accommodation space 122, and the LED die 102 may be disposed on a left side of the central axis 121, but this embodiment is not used to limit the present invention. That is to say, the LED die 102 may also be disposed on a right side of the central axis 121. It should be noted that distribution of the positions of the image planes 1141, 1142, 1143, 1144, and 1145 is changed according to a distance between the LED die 102 and the central axis 121 and a relative position of the LED die 102 and the central axis 121.

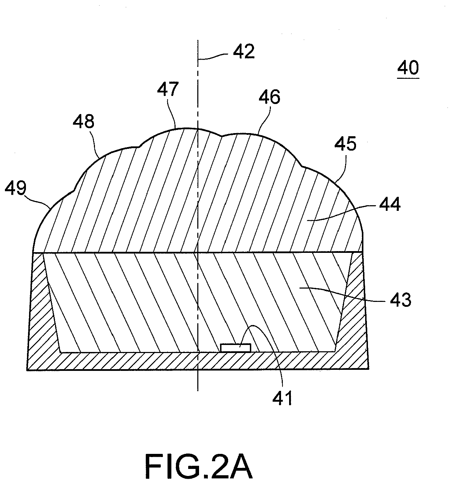

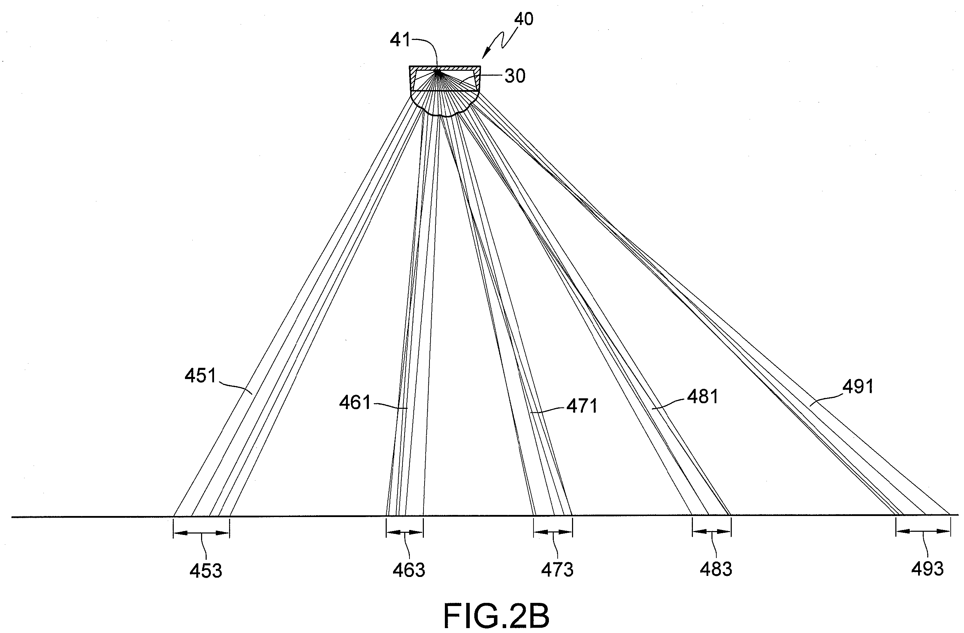

For example, referring to FIGs. 1B, 1C, 2A, 2B, 3A, 3B, 4A, and 4B, FIGs. 2A, 3A, and 4A are respectively schematic cross-sectional structural views of a second embodiment, a third embodiment, and a fourth embodiment of an LED packaging structure, and FIGs. 2B, 3B, and 4B are respectively schematic views of light beam trace according to FIGs. 2A, 3A, and 4A.

In FIGs. 2A and 2B, the LED packaging structure 40 comprises an LED die 41, a central axis 42, a package body 43, and a lens 44 (that is, an optical element), the package body 43 wraps the LED die 41, and the lens 44 is disposed on the package body 43. The lens 44 comprises a plurality of curved surfaces 45, 46, 47, 48, and 49, the LED die 41 emits a light beam 30, the light beam 30 passes through the curved surfaces 45, 46, 47, 48, and 49 and then is split into five sub-light beams 451, 461, 471, 481, and 491, and the sub-light beams 451, 461, 471, 481, and 491 are respectively projected onto image planes 453, 463, 473, 483, and 493.

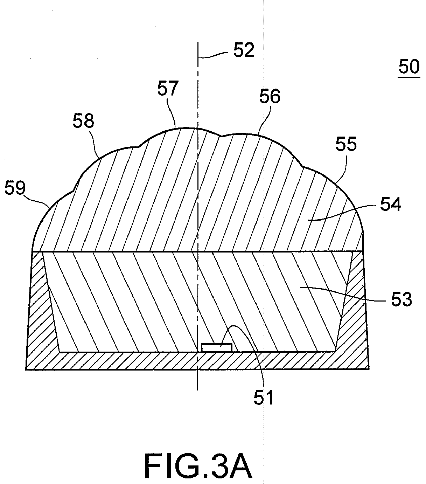

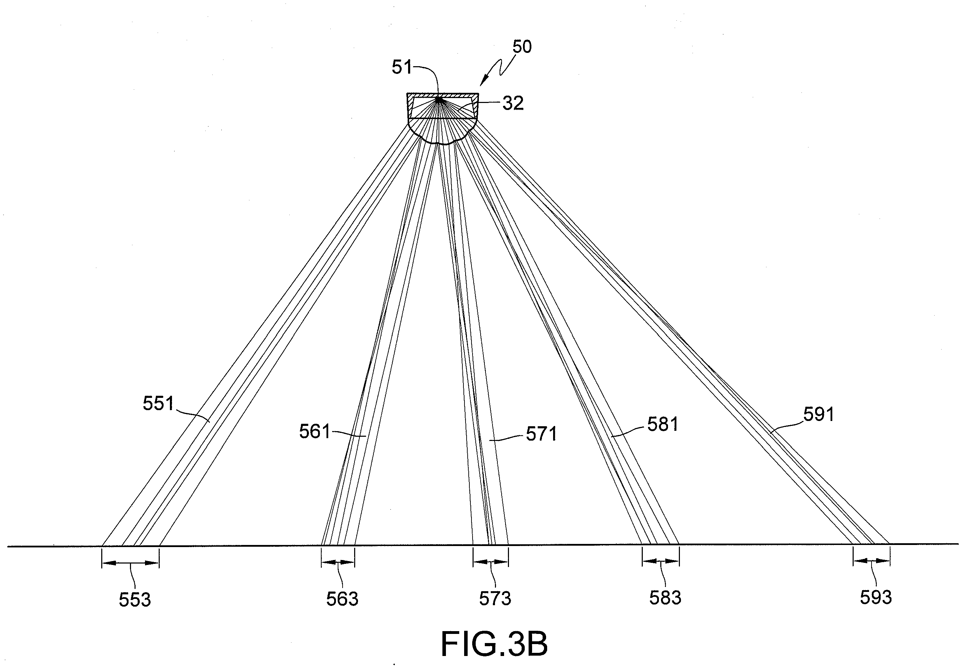

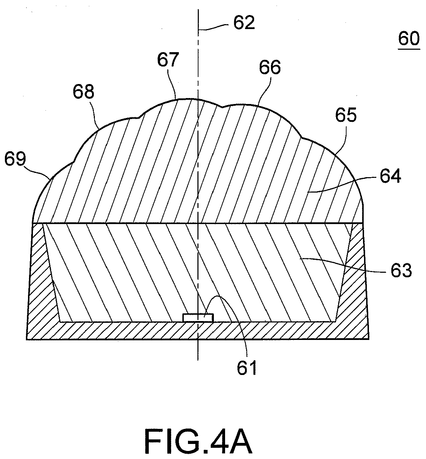

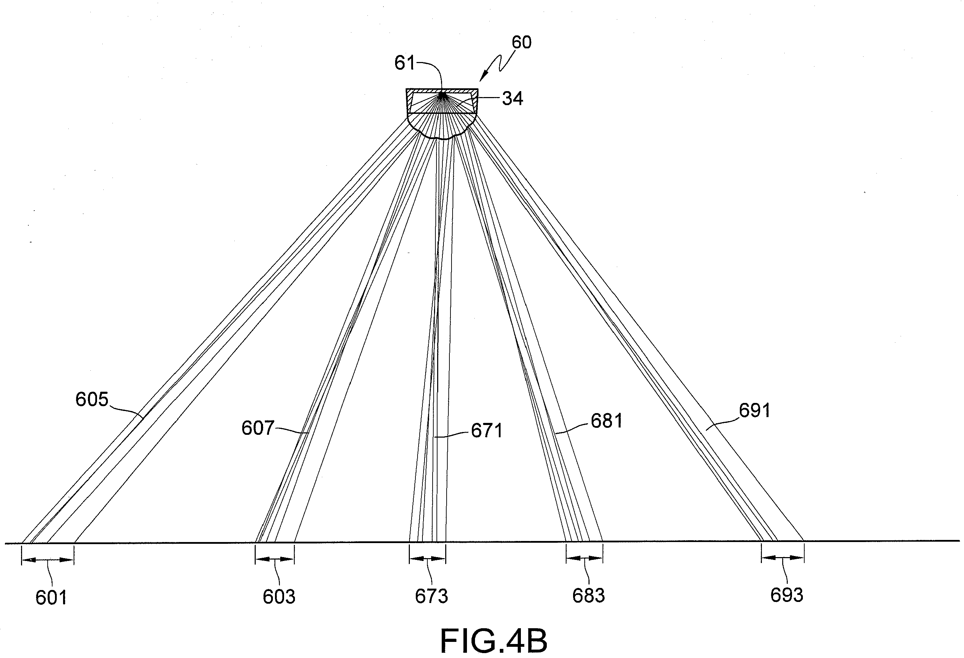

In FIGs. 3A and 3B, the LED packaging structure 50 comprises an LED die 51, a central axis 52, a package body 53, and a lens 54 (that is, an optical element), the package body 53 wraps the LED die 51, and the lens 54 is disposed on the package body 53. The lens 54 comprises a plurality of curved surfaces 55, 56, 57, 58, and 59, the LED die 51 emits a light beam 32, the light beam 32 passes through the curved surfaces 55, 56, 57, 58, and 59 and then is split into five sub-light beams 551, 561, 571, 581, and 591, and the sub-light beams 551, 561, 571, 581, and 591 are individually projected onto image planes 553, 563, 573, 583, and 593. In FIGs. 4A and 4B, an LED packaging structure 60 comprises an LED die 61, a central axis 62, a package body 63, and a lens 64 (that is, an optical element), the package body 63 wraps the LED die 61, and the lens 64 is disposed on the package body 63. The lens 64 comprises a plurality of curved surfaces 65, 66, 67, 68, and 69, the LED die 61 emits a light beam 34, the light beam 34 passes through the curved surfaces 65, 66, 67, 68, and 69 and then is split into five sub-light beams 605, 607, 671, 681, and 691, and the sub-light beams 605, 607, 671, 681, and 691 are individually projected onto image planes 601, 603, 673, 683, and 693.

Referring to FIGs. 1B, 2A, and 4A, the LED die 102 is disposed on the left side of the central axis 121, the LED die 41 is disposed on the right side of the central axis 42, and the LED die 61 is disposed on the central axis 62. Referring to FIGs. 1C, 2B, and 4B, the distribution of the positions of the image planes 1141, 1142, 1143, 1144, and 1145 is relatively on the right of FIG. 1C, the distribution of the positions of the image planes 453, 463, 473, 483, and 493 is relatively on the left of FIG. 2B, and the distribution of the positions of the image planes 601, 603, 673, 683, and 693 is relatively uniform in FIG. 4B. Therefore, the distribution of the positions of the image planes may be affected by the relative position of the LED die and the central axis.

Referring to FIG. 2A, 3A, and 4A, the LED die 41 is disposed on the right side of the central axis 42, the LED die 51 is disposed on the right side of the central axis 52, wherein a distance between the LED die 41 and the central axis 42 is larger than a distance between the LED die 51 and the central axis 52, and the LED die 61 is disposed on the central axis 62. Referring to FIGs. 2B, 3B, and 4B, the distribution of the positions of the image planes 453, 463, 473, 483, and 493 is relatively on the left of the drawing as compared with the distribution of the positions of the image planes 553, 563, 573, 583, and 593, and the distribution of the positions of the image planes 601, 603, 673, 683, and 693 is relatively uniform in FIG. 4B. Therefore, the distribution of the positions of the image planes may be affected by the distance between the LED die and the central axis.

Referring to FIG. 1C, the base 120 further comprises an inner side wall 123, the inner side wall 123 surrounds the accommodation space 122, and the light beam 116 incident to the inner side wall 123 is absorbed by the inner side wall 123, so as to prevent the inner side wall 123 from reflecting the light beam 116 to affect imaging quality of the LED packaging structure 100.

In the LED packaging structure, the plurality of image planes is obtained by controlling the amount of the curved surfaces. The positions of the image planes may be controlled according to the refraction index of the package body, the refraction index of the lens, and the curvature radius of each curved surface, wherein the refraction indices of the package body and the lens are affected by the wavelength of the light beam. Next, the distribution of the positions of the image planes may be affected by the distance between the LED die and the central axis and the relative position of the LED die and the central axis. Further, the light beam incident to the inner side wall may be absorbed by the inner side wall, thereby ensuring the imaging quality of the LED packaging structure.

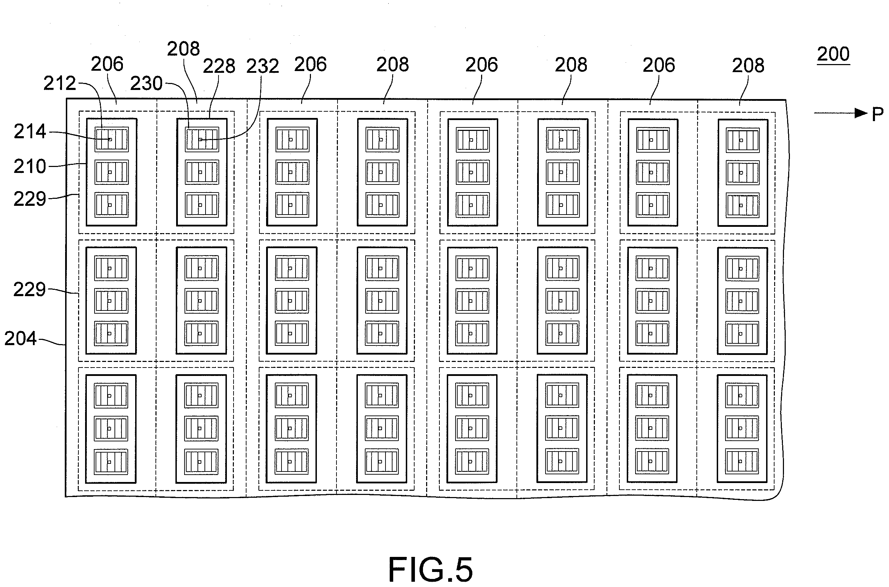

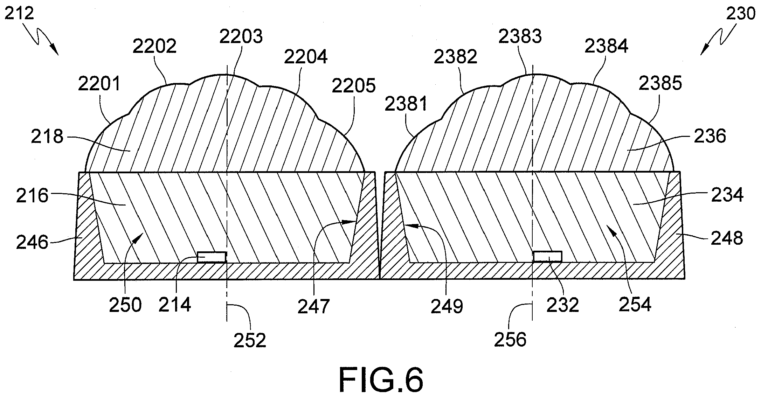

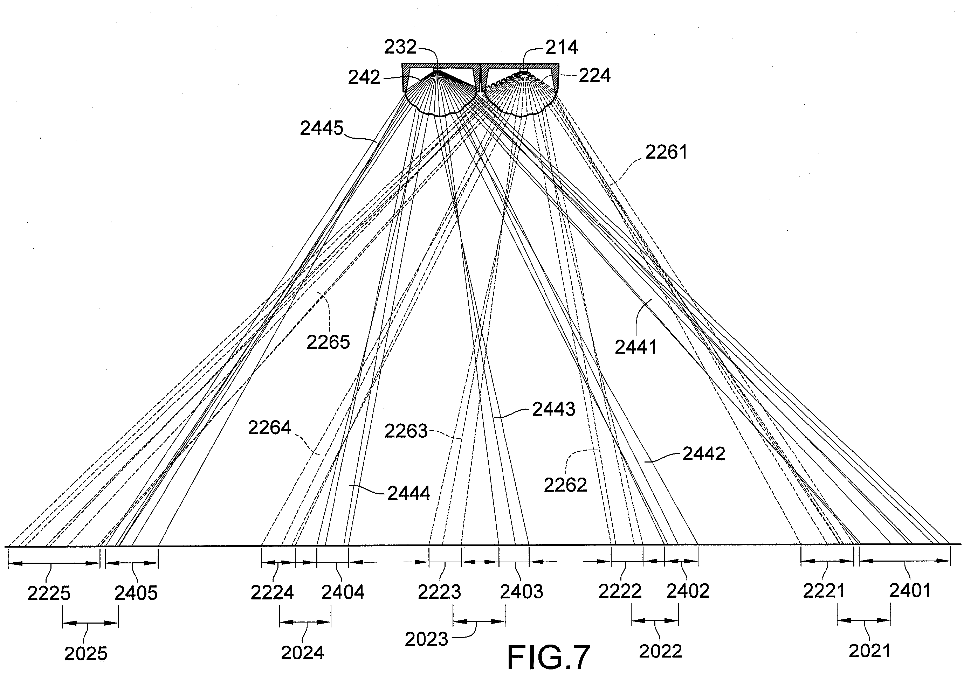

FIG. 5 is a schematic structural view of a first embodiment of an LED stereoscopic display device according to the present invention, FIG. 6 is a schematic cross-sectional structural view of a second LED packaging structure and a first LED packaging structure corresponding to the second LED packaging structure according to FIG. 5, and FIG. 7 is a schematic view of light beam trace according to FIG. 6. Referring to FIGs. 5, 6, and 7, the LED stereoscopic display device 200 has a plurality of viewable areas 2021, 2022, 2023, 2024, and 2025 (referring to FIG. 7), the viewable areas 2021, 2022, 2023, 2024, and 2025 are spaced by a distance. In this embodiment, the amount of the viewable areas is five, but this embodiment is not used to limit the present invention. The viewable areas 2021, 2022, 2023, 2024, and 2025 are areas where a viewer can view a stereoscopic image. FIG. 7 is the schematic view of light beam trace according to FIG. 6, so that each viewable area 2021, 2022, 2023, 2024, and 2025 is a line segment in FIG. 6. In this embodiment, each viewable area 2021, 2022, 2023, 2024, and 2025 may be disposed on the same plane, but this embodiment is not used to limit the present invention.

The LED stereoscopic display device 200 comprises a substrate 204, a plurality of first pixel areas 206, and a plurality of second pixel areas 208. The first pixel areas 206 and the second pixel areas 208 are alternately arranged along a direction P and disposed on the substrate 204. The imaging of the first pixel area 206 may be received by a right eye of the viewer, and the imaging of the second pixel area 208 may be received by a left eye of the viewer, but this embodiment is not used to limit the present invention. Each first pixel area 206 comprises a plurality of first pixel units 210, each first pixel unit 210 comprises a plurality of first LED packaging structures 212, and the amount of the first pixel units 210 of each first pixel area 206 and the amount of the first LED packaging structures 212 of each first pixel unit 210 may be adjusted according to actual demands.

Each first LED packaging structure 212 comprises a first LED die 214, a first package body 216, and a first optical element. In this embodiment, the first optical element may be, but not limited to, a first lens 218. The first package body 216 is used to wrap the first LED die 214, and the first lens 218 is disposed on the first package body 216. The first lens 218 comprises a plurality of first curved surfaces 2201, 2202, 2203, 2204, and 2205, and each first curved surface 2201, 2202, 2203, 2204, and 2205 respectively has a first image plane 2221, 2222, 2223, 2224, and 2225 corresponding to each first curved surface 2201, 2202, 2203, 2204, and 2205, wherein the amount of the first curved surfaces, the amount of the first image planes, and the amount of the viewable areas are the same. In this embodiment, the amount of the first curved surfaces is five, and the amount of the first image planes is five, but this embodiment is not used to limit the present invention.

The first LED die 202 emits a first light beam 224, the first light beam 224 passes through the first curved surfaces 2201, 2202, 2203, 2204, and 2205 and then is split into first sub-light beams 2261, 2262, 2263, 2264, and 2265, and the first sub-light beams 2261, 2262, 2263, 2264, and 2265 are respectively projected onto the first image planes 2221, 2222, 2223, 2224, and 2225. In this embodiment, each first image plane 2221, 2222, 2223, 2224, and 2225 may be disposed on the same plane, but this embodiment is not used to limit the present invention.

Each second pixel area 208 comprises a plurality of second pixel units 228, each second pixel unit 228 comprises a plurality of second LED packaging structures 230, and the amount of the second pixel units 228 of each second pixel area 208 and the amount of the second LED packaging structures 230 of each second pixel unit 228 may be adjusted according to actual demands. Each second pixel unit 228 corresponds to each first pixel unit 210, and each second LED packaging structure 230 corresponds to each first LED packaging structure 212, wherein each second pixel unit 228 and the each first pixel unit 210 corresponding to each second pixel unit 228 form a pixel 229. Each second LED packaging structure 230 comprises a second LED die 232, a second package body 234, and a second optical element. In this embodiment, the second optical element may be, but not limited to, a second lens 236. The second package body 234 is used to wrap the second LED die 232, and the second lens 236 is disposed on the second package body 234.

The second lens 236 comprises a plurality of second curved surfaces 2381, 2382, 2383, 2384, and 2385, and each second curved surface 2381, 2382, 2383, 2384, and 2385 respectively has a second image plane 2401, 2402, 2403, 2404, and 2405 corresponding to each second curved surface 2381, 2382, 2383, 2384, and 2385, wherein the amount of the second curved surfaces is the same as the amount of the first curved surfaces, and the amount of second image planes is the same as the amount of the viewable areas. In this embodiment, the amount of the second curved surfaces is five, and the amount of the second image plane is five, but this embodiment is not used to limit the present invention.

The second LED die 232 emits a second light beam 242, the second light beam 242 respectively passes through the second curved surfaces 2381, 2382, 2383, 2384, and 2385 and then is split into second sub-light beams 2441, 2442, 2443, 2444, and 2445. The second sub-light beams 2441, 2442, 2443, 2444, and 2445 are respectively projected onto the second image planes 2401, 2402, 2403, and 2404, 2405. In this embodiment, each second image plane 2401, 2402, 2403, 2404, and 2405 may be disposed on the same plane, but this embodiment is not used to limit the present invention.

The amount of the first image planes is the same as the amount of the second image planes, and each second image plane 2401, 2402, 2403, 2404, and 2405 respectively corresponds to each first image plane 2221, 2222, 2223, 2224, and 2225. A part of the second image planes 2401, 2402, 2403, 2404, and 2405 and a part of the first image planes 2221, 2222, 2223, 2224, and 2225 corresponding to the second image planes 2401, 2402, 2403, 2404, and 2405 may form the viewable areas 2021, 2022, 2023, 2024, and 2025. That is to say, a part of the second image plane 2401 and a part of the first image plane 2221 corresponding to the second image plane 2401 may form the viewable area 2021, a part of the second image plane 2402 and a part of the first image plane 2222 corresponding to the second image plane 2402 may form the viewable area 2022, a part of the second image plane 2403 and a part of the first image plane 2223 corresponding to the second image plane 2403 may form the viewable area 2023, a part of the second image plane 2404 and a part of the first image plane 2224 corresponding to the second image plane 2404 may form the viewable area 2024, and a part of the second image plane 2405 and a part of the first image plane 2225 corresponding to the second image plane 2405 may form the viewable area 2025.

In this embodiment, each first package body 216 and each first lens 218 have different refraction indices (not shown), each second package body 234 and each second lens 236 have different refraction indices (not shown), and the first curved surfaces 2201, 2202, 2203, 2204, and 2205 and the second curved surfaces 2381, 2382, 2383, 2384, and 2385 have different first curvature radiuses and different second curvature radiuses. A position of each first image plane 2221, 2222, 2223, 2224, and 2225 is decided according to the refraction index of each first package body 216, the refraction index of each first lens 218, and the first curvature radius of each first curved surface 2201, 2202, 2203, 2204, and 2205, a position of each second image plane 2401, 2402, 2403, 2404, and 2405 is decided according to the refraction index of each second package body 234, the refraction index of each second lens 236, and the second curvature radius of each second curved surface 2381, 2382, 2383, 2384, and 2385, and a position of each viewable area 2021, 2022, 2023, 2024, and 2025 is decided according to the position of each first image plane and the position of each second image plane adjacent to each first image plane. The refraction indices of the first package body 216 and the first lens 218 are affected by a wavelength of the first light beam 224, and the refraction indices of the second package body 234 and the second lens 236 are affected by a wavelength of the second light beam 242.

Each first pixel unit 210 comprises three first LED packaging structures 212, and the first LED packaging structures 212 comprise a red LED die, a blue LED die, and a green LED die; and each second pixel unit 228 comprises three second LED packaging structures 230, and the second LED packaging structures 230 comprise a red LED die, a blue LED die, and a green LED die. The three first LED packaging structures 212 may be, but not limited to be, linearly arranged, and the three second LED packaging structures 230 may be, but not limited to be, linearly arranged. In this embodiment, the amount of the first LED packaging structures 212 of each first pixel unit 210 may be, but not limited to, three, and the amount of the second LED packaging structures 230 of each second pixel unit 228 may be, but not limited to, three. Actually, the amount of the first LED packaging structures 212 of each first pixel unit 210 and the amount of the second LED packaging structures 230 of each second pixel unit 228 may be adjusted according to the actual demands.

Referring to FIG. 6, each first LED packaging structure 212 further comprises a first base 246, each second LED packaging structure 230 further comprises a second base 248, each first base 246 comprises a first accommodation space 250 and a first central axis 252, each second base 248 comprises a second accommodation space 254 and a second central axis 256, the first LED die 214 is disposed in the first accommodation space 250, the second LED die 232 is disposed in the second accommodation space 254, the first LED die 214 is disposed on a left side of the first central axis 252, and the second LED die 232 is disposed on a right side of the second central axis 256, but this embodiment is not used to limit the present invention. It should be noted that a distance between the first LED die 214 and the first central axis 252 is changed according to the position of the first LED packaging structure 212 on the substrate 204, and a distance between the second LED die 232 and the second central axis 256 is changed according to the position of the second LED packaging structure 230 on the substrate 204.

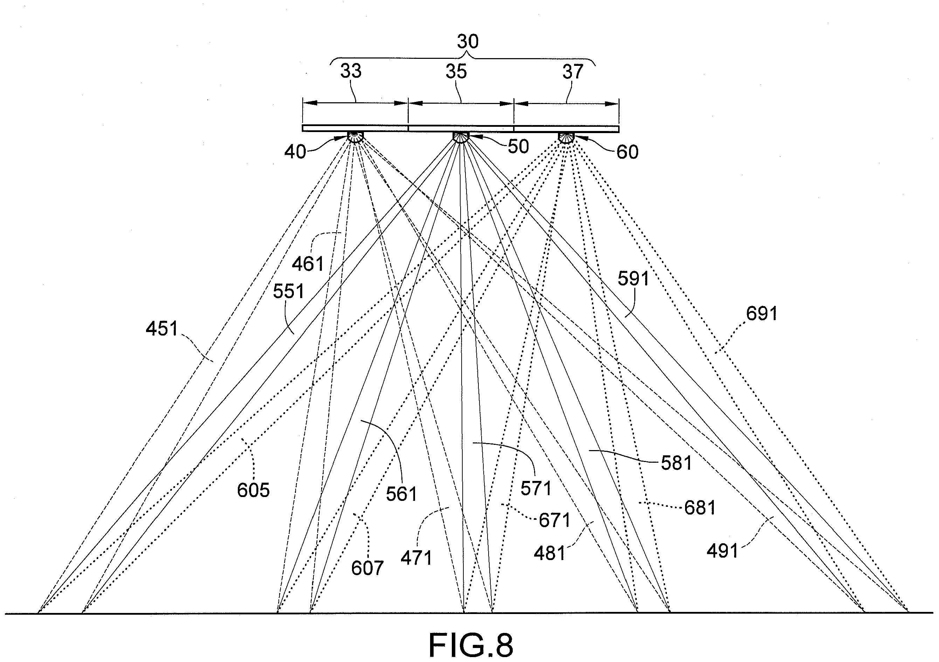

For example, FIG. 8 is a schematic view of light beam trace of an embodiment wherein the LED packaging structures of FIGs. 2A, 3A, and 4A are disposed on different positions of the same substrate respectively. Referring to FIG. 8, the substrate 31 comprises a first area 33, a second area 35, and a third area 37, and the first area 33, the second area 35, and the third area 37 are on the same horizontal plane (not shown). Referring to FIGs. 2A, 3A, 4A, and 8, the LED packaging structure 40, the LED packaging structure 50, and the LED packaging structure 60 are respectively disposed in the first area 33, the second area 35, and the third area 37, and the light beams 30, 32, and 34 emitted by the LED packaging structure 40, the LED packaging structure 50, and the LED packaging structure 60 can be received by a right eye of a viewer, but this embodiment is not used to limit the present invention. The LED packaging structure 40, the LED packaging structure 50, and the LED packaging structure 60 are disposed on different positions of the substrate 30, so that the sub-light beams 451, 551, and 605 are projected onto the same image plane (that is, the image plane 453, the image plane 553, and the image plane 601 coincide with one another), the sub-light beams 461, 561, and 607 are projected onto the same image plane (that is, the image plane 463, the image plane 563, and the image plane 603 coincide with one another), the sub-light beams 471, 571, and 671 are projected onto the same image plane (that is, the image plane 473, the image plane 573, and the image plane 673 coincide with one another), the sub-light beams 481, 581, and 681 are projected onto the same image plane (that is, the image plane 483, the image plane 583, and the image plane 683 coincide with one another), and the sub-light beams 491, 591, and 691 are projected onto the same image plane (that is, the image plane 493, the image plane 593, and the image plane 693 coincide with one another). Therefore, when the LED packaging structure is applied to the LED stereoscopic display device, and the light beams emitted by the LED packaging structures are received by the same eye (the left eye or the right eye) of the viewer, the distance between the LED die and the central axis may be changed according to the position of the LED packaging structure on the substrate.

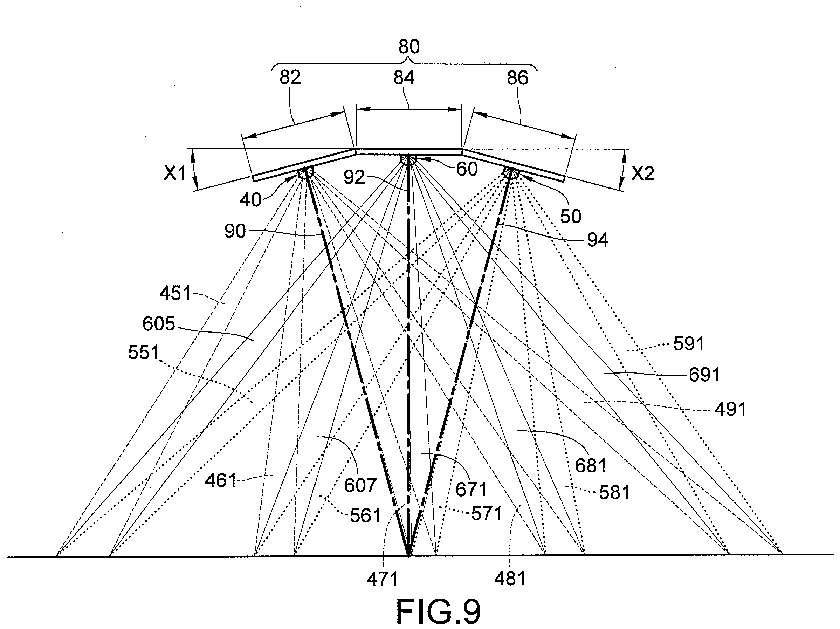

In addition, FIG. 9 is a schematic view of light beam trace of another embodiment wherein the LED packaging structures of FIGs. 2A, 3A, and 4A are disposed on different positions of the same substrate respectively. Referring to FIG. 9, the substrate 80 comprises a first area 82, a second area 84, and a third area 86, a first included angle X₁ is formed between the first area 82 and an extension line of the second area 84, and a second included angle X₂ is formed between the extension line of the second area 84 and the third area 86, wherein the first included angle X₁ and the second included angle X₂ enable central axis 90 of the first area 82, central axis 92 of the second area 84, and central axis 94, of the third area 86 to intersect at one point. Referring to FIGs. 2A ,3A, 4A, and 9, the LED packaging structure 40, the LED packaging structure 50, and the LED packaging structure 60 are respectively disposed in the first area 82, the third area 86, and the second area 84, and the light beams 30 emitted by the LED packaging structure 40, the light beams 32 emitted by the LED packaging structure 50, and the light beams 34 emitted by the LED packaging structure 60 may be received by the right eye of the viewer, but this embodiment is not used to limit the present invention. That is to say, the LED packaging structure 40, the LED packaging structure 50, and the LED packaging structure 60 are disposed on the different position of the substrate 80, so that the sub-light beams 451, 551, and 605 are projected onto the same image plane (that is, the image plane 453, the image plane 553, and the image plane 601 coincide with one another), the sub-light beams 461, 561, and 607 are projected onto the same image plane (that is, the image plane 463, the image plane 563, and the image plane 603 coincide with one another), the sub-light beams 471, 571, and 671 are projected onto the same image plane (that is, the image plane 473, the image plane 573, and the image plane 673 coincide with one another), the sub-light beams 481, 581, and 681 are projected onto the same image plane (that is, the image plane 483, the image plane 583, and the image plane 683 coincide with one another), and the sub-light beams 491, 591, and 691 are projected onto the same image plane (that is, the image plane 493, the image plane 593, and the image plane 693 coincide with one another). Therefore, when the LED packaging structure is applied to the LED stereoscopic display device, and the light beams emitted by the LED packaging structures are viewed by the same eye (the left eye or the right eye) of the viewer, the clear stereoscopic image may be obtained by controlling the disposed positions of the LED packaging structures on the substrate, the first included angle X₁, and the second included angle X₂.

Referring to FIG. 6, the first base 246 further comprises a first inner side wall 247, the first inner side wall 247 surrounds the first accommodation space 250, and the first light beam 224 incident to the first inner side wall 247 is absorbed by the first inner side wall 247, so as to prevent the first inner side wall 247 from reflecting the first light beam 224 to affect imaging quality of the first LED packaging structure 212. The second base 248 further comprises a second inner side wall 249, the second inner side wall 249 surrounds the second accommodation space 254, and the second light beam 242 incident to the second inner side wall 249 is absorbed by the second inner side wall 249, so as to prevent the second inner side wall 249 from reflecting the second light beam 242 to affect imaging quality of the second LED packaging structure 230.

In the LED stereoscopic display device according to the present invention, the amount and the positions of the viewable areas may be controlled by the relative disposition and the design of the first LED packaging structures and the design of the second LED packaging structures (that is, the amount of the first curved surfaces and the amount of the second curved surfaces, the refraction index of the first package body , the refraction index of the second package body, the refraction index of the first lens , the refraction index of the second lens, the curvature radiuses of each first curved surface and the curvature radiuses of each second curved surface), and the distance between the first LED die and the first central axis and the distance between the second LED die and the second central axis are respectively changed according to the position of the first LED packaging structure and the position of the second LED packaging structure on the substrate, so that the LED stereoscopic display device has the plurality of viewable areas. Next, each first LED packaging structure and each second LED packaging structure may be adjusted according to the actual demands, so that the quality of the stereoscopic image viewed by the eyes of the viewer is not affected by the changes of the distance between the viewer and the LED stereoscopic display device distance, and the problem of the conventional LED stereoscopic display device that difficulties exist in the manufacturing process is solved. Further, through the design of the first inner side wall and the second inner side wall, the quality of the stereoscopic image shown by the LED stereoscopic display device may be improved.

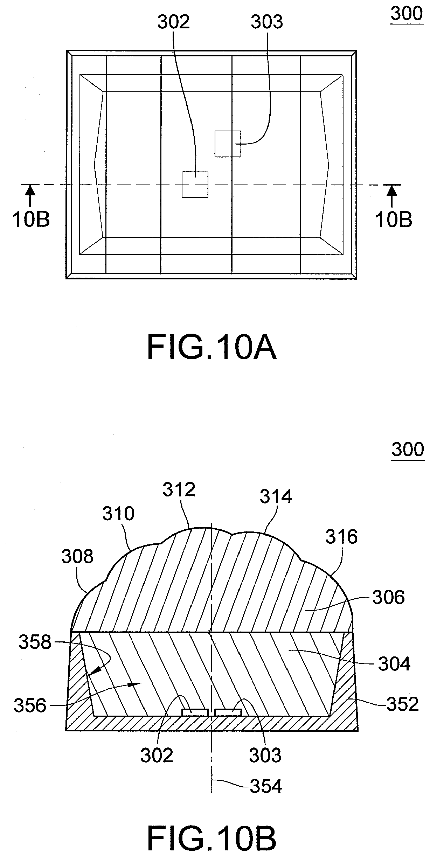

FIG. 10A is a schematic top structural view of a fifth embodiment of an LED packaging structure, and FIG. 10B is a schematic cross-sectional structural view according to Line 10B-10B of FIG. 10A. Referring to FIGs. 10A and 10B, the LED packaging structure 300 comprises a first LED die 302, a second LED die 303, a package body 304, and an optical element. In this embodiment, the optical element may be, but not limited to, a lens 306. The package body 304 wraps the first LED die 302 and the second LED die 303, and the lens 306 is disposed on the package body 304.

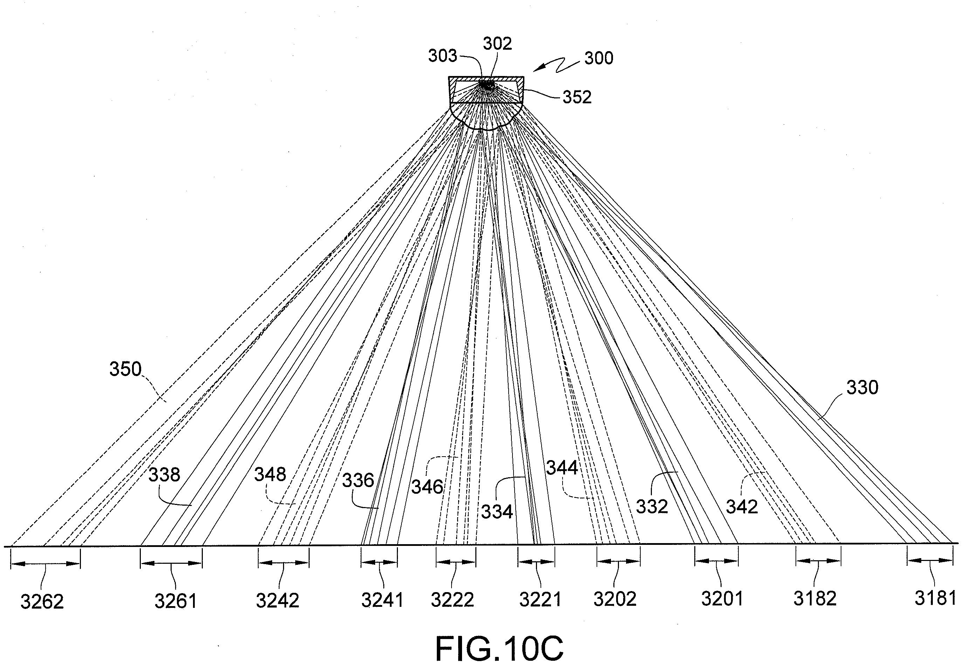

FIG. 10C is a schematic view of light beam trace according to FIG. 10B. Referring to FIG. 10C, the lens 306 comprises a plurality of curved surfaces 308, 310, 312, 314, and 316, each curved surface 308, 310, 312, 314, and 316 respectively has a first image plane 3181, 3201, 3221, 3241, and 3261 and a second image plane 3182, 3202, 3222, 3242, and 3262 corresponding to each curved surface 308, 310, 312, 314, and 316. In this embodiment, the amount of the curved surfaces is five, and the amount of the first image planes and the amount of the second image planes are also five, but this embodiment is not used to limit the present invention. That is to say, when the amount of the curved surfaces is six, the amount of the first image planes and the amount of the second image planes are also six. More specifically, the larger the amount of the curved surfaces is, the larger the amount of the first image planes and the amount of the second image planes are. FIG. 10C is the schematic view of light beam trace according to FIG. 10B, so that each first image plane 3181, 3201, 3221, 3241, and 3261 and each second image plane 3182, 3202, 3222, 3242, and 3262 are a line segment in FIG. 10C. In this embodiment, each first image plane 3181, 3201, 3221, 3241, and 3261 and each second image plane 3182, 3202, 3222, 3242, and 3262 may be disposed on the same plane, but this embodiment is not used to limit the present invention.

The first LED die 302 emits a first light beam (as shown by a real line in the package body 304), the first light beam (as shown by the real line in the package body 304) emitted by the first LED die 302 passes through the plurality of curved surfaces 308, 310, 312, 314, and 316 and then is split into a plurality of first sub-light beams 330, 332, 334, 336, and 338, and the first sub-light beams 330, 332, 334, 336, and 338 are projected onto the first image planes 3181, 3201, 3221, 3241, and 3261 corresponding to the first sub-light beams 330, 332, 334, 336, and 338. The amount of the first sub-light beams is the same as the amount of the curved surfaces. The second LED die 303 emits a second light beam (as shown by a dashed line in the package body 304), the second light beam (as shown by the dashed line in the package body 304) emitted by the second LED die 303 passes through the plurality of curved surfaces 308, 310, 312, 314, and 316 and then is split into a plurality of second sub-light beams 342, 344, 346, 348, and 350, and the second sub-light beams 342, 344, 346, 348, and 350 are projected onto the second image planes 3182, 3202, 3222, 3242, and 3262 corresponding to the second sub-light beams 342, 344, 346, 348, and 350. The amount of the second sub-light beams is the same as the amount of the curved surfaces.

In this embodiment, the package body 304 and the lens 306 have different refraction indices (not shown), each of the curved surfaces 308, 310, 312, 314, and 316 respectively have a curvature radius (not shown), positions of the first image planes 3181, 3201, 3221, 3241, and 3261 are decided according to the refraction index of the package body 304, the refraction index of the lens 306, and the curvature radiuses of the curved surfaces 308, 310, 312, 314, and 316, and positions of the second image planes 3182, 3202, 3222, 3242, and 3262 are decided according to the refraction index of the package body 304, the refraction index of the lens 306, and the curvature radiuses of the curved surfaces 308, 310, 312, 314, and 316. The refraction index of the package body 304 is changed according to wavelengths of different light beams (that is, the first light beam emitted by the first LED die 302 and the second light beam emitted by the second LED die 303).

Referring to FIG. 10B, the LED packaging structure 300 further comprises a base 352, and the base 352 comprises a central axis 354 and an accommodation space 356. The first LED die 302 and the second LED die 303 are disposed in the accommodation space 356, the LED die 302 may be disposed on a left side of the central axis 354, and the second LED die 303 may be disposed on a right side of the central axis 354, but this embodiment is not used to limit the present invention. It should be noted that distribution of the positions of the first image planes 3181, 3201, 3221, 3241, and 3261 may be affected by a distance between the first LED die 302 and the central axis 354 and a relative position of the first LED die 302 and the central axis 354, and distribution of the positions of the second image planes 3182, 3202, 3222, 3242, and 3262 may be affected by a distance between the second LED die 303 and the central axis 354 and a relative position of the second LED die 303 and the central axis 354. The part about above-mentioned is similar to the situation described in the above embodiments, and is not described in detail here.

Referring to FIG. 10C, the first image planes 3181, 3201, 3221, 3241, and 3261 correspond to the second image planes 3182, 3202, 3222, 3242, and 3262, and the first image planes 3181, 3201, 3221, 3241, and 3261 are disposed on one side of the second image planes 3182, 3202, 3222, 3242, and 3262 corresponding to the first image planes 3181, 3201, 3221, 3241, and 3261. That is to say, the first image planes 3181, 3201, 3221, 3241, and 3261 and the second image planes 3182, 3202, 3222, 3242, and 3262 are alternately arranged.

Referring to FIG. 10B, the base 352 further comprises an inner side wall 358, the inner side wall 358 surrounds the accommodation space 356, and the first light beam (as shown by the real line in the package body 304) and the second light beam (as shown by the dashed line in the package body 304) incident to the inner side wall 358 are absorbed by the inner side wall 358, so as to prevent the inner side wall 358 from reflecting the first light beam and the second light beam to affect imaging quality of the LED packaging structure 300.

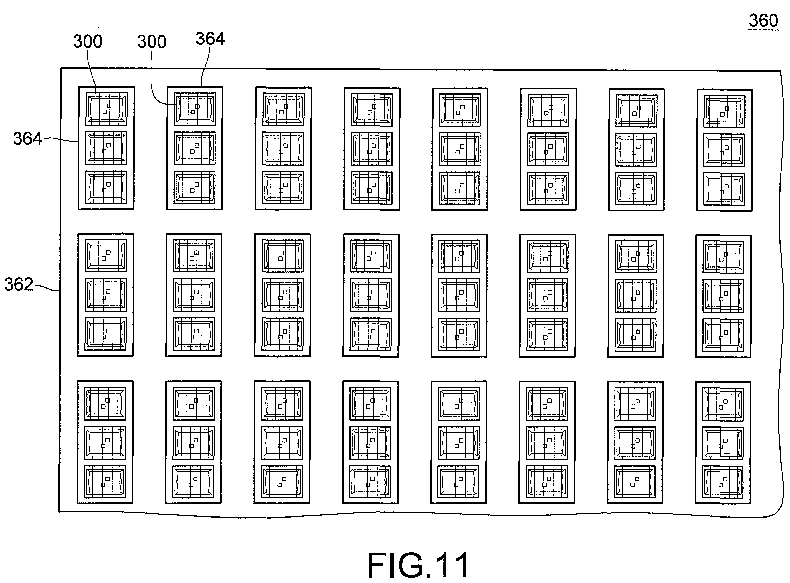

FIG. 11 is a schematic structural view of an embodiment in which the LED packaging structure according to FIG. 10B is applied to an LED stereoscopic display device which is not part of the invention. The LED stereoscopic display device 360 comprises a substrate 362 and a plurality of pixel areas 364, each pixel area 364 is disposed on the substrate 362, each pixel area 364 may comprise, but not limited to, three LED packaging structures 300, and each pixel area 364 is a pixel. The three first LED dies 302 of each pixel area 364 may be, but not limited to, a red LED die, a green LED die, and a blue LED die, the three second LED dies 303 of each pixel area 364 may be, but is not limited to, a red LED die, a green LED die, and a blue LED die, and the three LED packaging structures 300 may be, but not limited to be, linearly arranged. In this embodiment, the amount of the LED packaging structures 300 of each pixel area 364 is three, and actually the amount of the LED packaging structures 300 of each pixel area 364 may be adjusted according to demands.

In this embodiment, the distance between the first LED die 302 and the central axis 354 and the distance between the second LED die 303 and the central axis 354 are changed according to the position of the LED packaging structure 300 on the substrate 362. The part about above-mentioned is described in the above embodiments, and is not described in detail here.

Referring to FIG. 10C, the LED stereoscopic display device 360 comprises five viewable areas, and each viewable area is formed by an adjacent area of each first image plane 3181, 3201, 3221, 3241, and 3261 on which each LED packaging structure 300 is projected and each second image plane 3182, 3202, 3222, 3242, and 3262 corresponding to each first image plane 3181, 3201, 3221, 3241, and 3261.

In the LED packaging structure, the amount and the positions of the first image planes and the amount and the positions of the second image planes may be controlled by the design of the amount of the curved surfaces, the refraction index of the package body, and the curvature radius of each curved surface, thereby achieving a multi-viewing angle objective. Next, the distribution of the positions of the first image planes and the distribution of the positions of the second image planes may also be affected by the distance between the first LED die and the central axis, the distance between the second LED die and the central axis, a relative positions of the first LED die and the central axis, and a relative positions of the second LED die and the central axis. Further, the light beams incident to the inner side wall may be absorbed by the inner side wall, so as to ensure the imaging quality of the LED packaging structure.

The LED packaging structure is applied to the LED stereoscopic display device, so that the LED stereoscopic display device comprises a plurality of viewable areas. Further, the light beams incident to the inner side wall may be absorbed by the inner side wall, so as to ensure stereoscopic imaging quality of the LED stereoscopic display device.

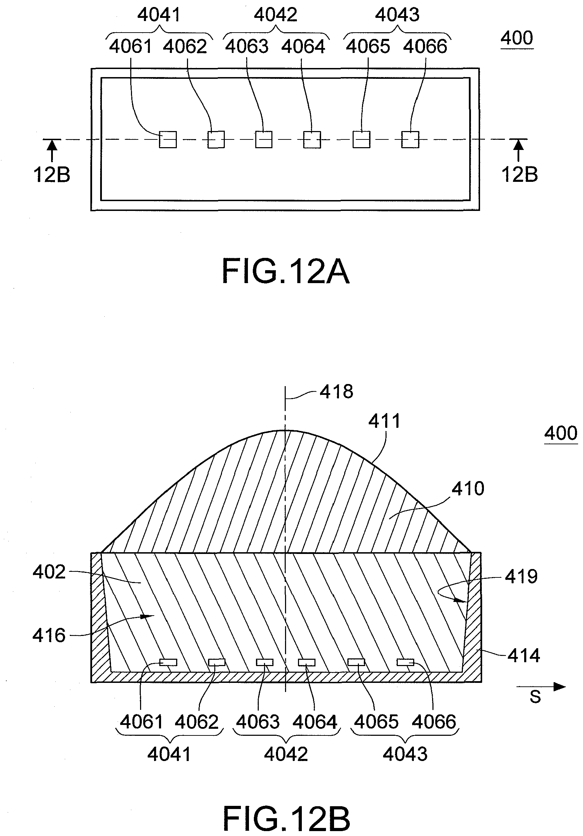

FIG. 12A is a schematic top structural view of a design of an LED packaging structure, with said figure not showing all features of the present invention, and FIG. 12B is a schematic cross-sectional structural view according to Line 12B-12B of FIG. 12A. Referring to FIGs. 12A and 12B, the LED packaging structure 400 comprises a package body 402, a first light emitting unit 4041, a second light emitting unit 4042, a third light emitting unit 4043, and an optical element. In this embodiment, the optical element may be, but not limited to, a lens 410. In this embodiment, the amount of the light emitting units is three, but this embodiment is not used to limit the present invention. The package body 402 is used to wrap the first light emitting unit 4041, the second light emitting unit 4042, and the third light emitting unit 4043, and the lens 410 is disposed on the package body 402.

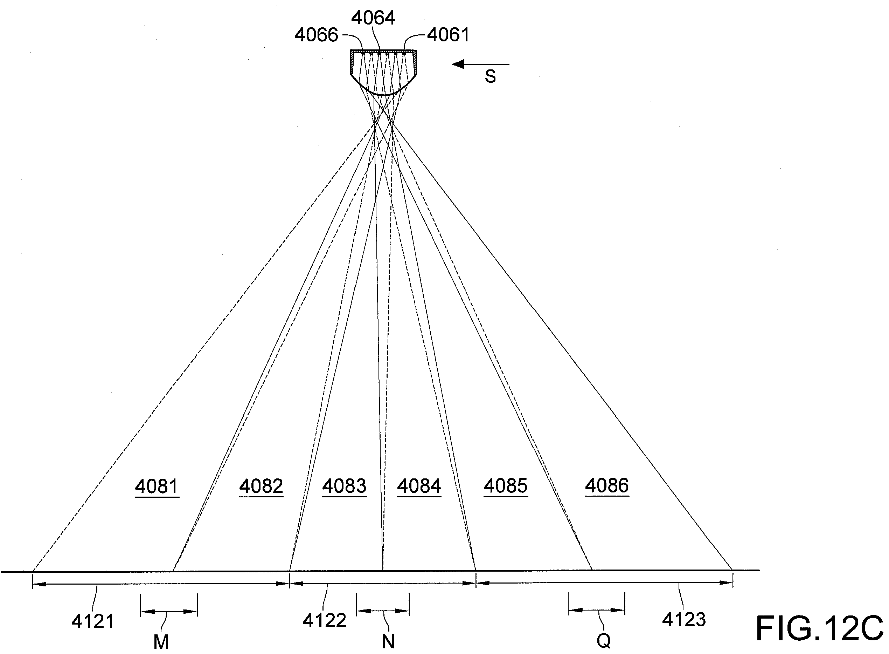

FIG. 12C is a schematic view of light beam trace according to FIG. 12B. Referring to FIG. 12C, the first light emitting unit 4041 comprises a first LED die 4061 and a second LED die 4062, the first LED die 4061 emits a first light beam 4081, and the second LED die 4062 emits a second light beam 4082. The second light emitting unit 4042 comprises a first LED die 4063 and a second LED die 4064, the first LED die 4063 emits a first light beam 4083, and the second LED die 4064 emits a second light beam 4084. The third light emitting unit 4043 comprises a first LED die 4065 and a second LED die 4066, the first LED die 4065 emits a first light beam 4085, and the second LED die 4066 emits a second light beam 4086. The first light emitting unit 4041, the second light emitting unit 4042, and the three light emitting unit 4043 are arranged in sequence along a direction S. More specifically, the sequence of arrangement along the direction S is the first LED die 4061, the second LED die 4062, the first LED die 4063, the second LED die 4064, the first LED die 4065, and the second LED die 4066, but this embodiment is not used to limit the present invention.

The lens 410 comprises a curved surface 411, the first light beam 4081 and the second light beam 4082 respectively pass through a part of the curved surface 411 and are respectively projected onto an image plane 4121, and a position of the first light beam 4081 projected onto the image plane 4121 is disposed on one side of a position of the second light beam 4082 projected onto the image plane 4121. The first light beam 4083 and the second light beam 4084 respectively pass through a part of the curved surface 411 and are respectively projected onto an image plane 4122, and a position of the first light beam 4083 projected onto the image plane 4122 is disposed on one side of a position of the second light beam 4084 projected onto the image plane 4122. The first light beam 4085 and the second light beam 4086 respectively pass through a part of curved surface 411 and are respectively projected onto the image plane 4123, and a position of the first light beam 4085 projected onto the image plane 4123 is disposed on one side of the second light beam 4086 projected onto the image plane 4123.

FIG. 12C is the schematic view of light beam trace according to FIG. 12B, so that each image plane 4121, 4122, and 4123 is a line segment in FIG. 12C. In this embodiment, each image plane 4121, 4122, and 4123 may be disposed on the same plane, but this embodiment is not used to limit the present invention.

Referring to FIG. 12B, the LED packaging structure 400 further comprises a base 414, the base 414 comprises an accommodation space 416 and a central axis 418, the light emitting unit 4041, the light emitting unit 4042, and the light emitting unit 4043 are disposed in the accommodation space 416, the central axis 418 may be disposed in the middle of the first LED die 4063 and the second LED die 4064, so that the amount of the LED dies on two sides of the central axis 418 is the same (that is to say, the first LED die 4061, the second LED die 4062, and the first LED die 4063 are on a left side of the central axis 418, and the second LED die 4064, the first LED die 4065, and the second LED die 4066 are on a right side of the central axis 418), but this embodiment is not used to limit the present invention.

The base 414 further comprises an inner side wall 419, the inner side wall 419 surrounds the accommodation space 416, and the light beams (that is, the first light beams 4081, 4083, and 4085 and the second light beams 4082, 4084, and 4086) incident to the inner side wall 419 are absorbed by the inner side wall 419, so as to prevent the inner side wall 419 from reflecting the light beams (that is, the first light beams 4081, 4083, and 4085 and the second light beams 4082, 4084, and 4086) to affect imaging quality of the LED packaging structure 400.

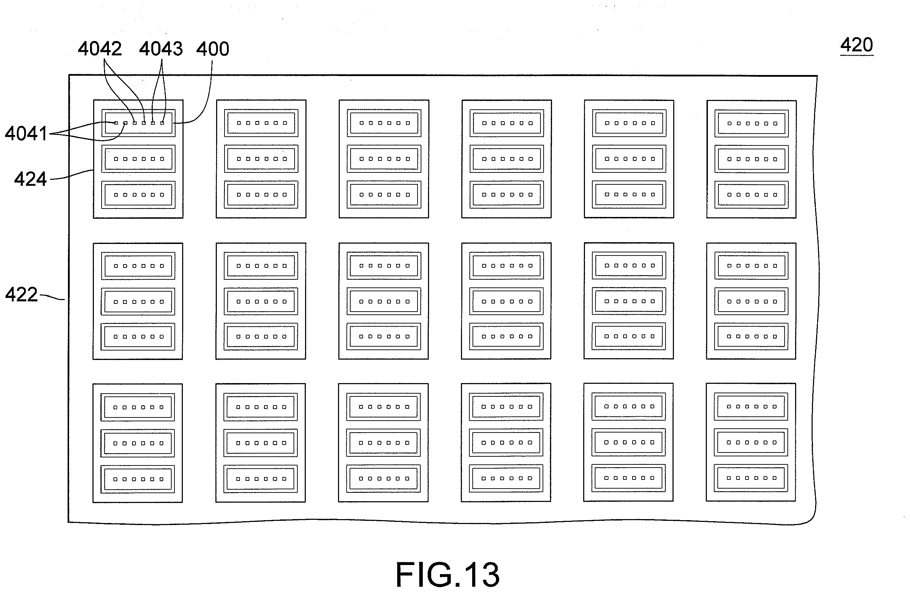

FIG. 13 is a schematic structural view of an embodiment in which the LED packaging structure according to FIG. 12B is applied to an LED stereoscopic display device which is not part of the invention. Referring to FIG. 13, the LED stereoscopic display device 420 comprises a substrate 422 and a plurality of LED packaging structures 400, and each LED packaging structure 400 is disposed on the substrate 422. The LED stereoscopic display device 420 further comprises a plurality of pixel areas 424, each pixel area 424 may comprise, but not limited to, three LED packaging structures 400, and the three LED packaging structures 400 may be, but not limited to be, linearly arranged. At least three first light emitting units 4041, three second light emitting units 4042, or three third light emitting units 4043 form a pixel (not shown). For example, when each pixel is formed by three first light emitting units 4041, each first LED die 4061 comprises a red LED die, a green LED die, and a blue LED die. In this embodiment, each pixel area 424 comprises three LED packaging structures 400, in which the three LED packaging structures 400 may be, but not limited to, linearly arranged three LED packaging structures 400, and the three first LED dies 4061 comprise a red LED die, a green LED die, and a blue LED die, but this embodiment is not used to limit the present invention.

In this embodiment, distances between the first LED dies 4061, 4063, and 4065 and the central axis 418 and distances between the second LED dies 4062, 4064, and 4066 and the central axis 418 are changed according to a position of the LED packaging structure 400 on the substrate 422. The part about above-mentioned is described in the embodiment, and it not described in detail here.

The LED stereoscopic display device 420 has a plurality of viewable areas, taking this embodiment as an example, the LED stereoscopic display device 420 according to this embodiment has three viewable areas M, N, and Q, the viewable area M is an adjacent area of the position of the first light beam 4081 projected onto the image plane 4121 and the position of the second light beam 4082 projected onto the image plane 4121, the viewable area N is an adjacent area of the position of the first light beam 4083 projected onto the image plane 4122 and the position of the second light beam 4084 projected onto the image plane 4122, and the viewable area Q is an adjacent area of the position of the first light beam 4085 projected onto the image plane 4123 and the position of the second light beam 4086 projected onto the image plane 4123, but this embodiment is not used to limit the present invention.

Therefore, in the LED packaging structure, the amount of the image planes may be adjusted by controlling the amount of the light emitting units. The positions of the image planes may be adjusted by the refraction index of the package body and the design of the curved surface, so that the image planes are not overlapped to generate interference. Next, the LED packaging structure is applied to the LED stereoscopic display device, so that the viewer may view different stereoscopic image at different viewable areas, and the different stereoscopic images doe not interfere with each other. The LED stereoscopic display device according to the present invention is formed by the plurality of LED packaging structures, and each LED packaging structure may be designed and adjusted according to actual demands, thereby eliminating the problems of the conventional LED stereoscopic display device that the manufacturing process is difficult, and the quality of the image is changed when a distance between eyes of the viewer and the LED stereoscopic display device is changed.

In the above embodiments, each curved surface is lenticular for representation and description, but the embodiments are not used to limit the present invention. That is to say, each curved surface may be in a form of Fresnel.

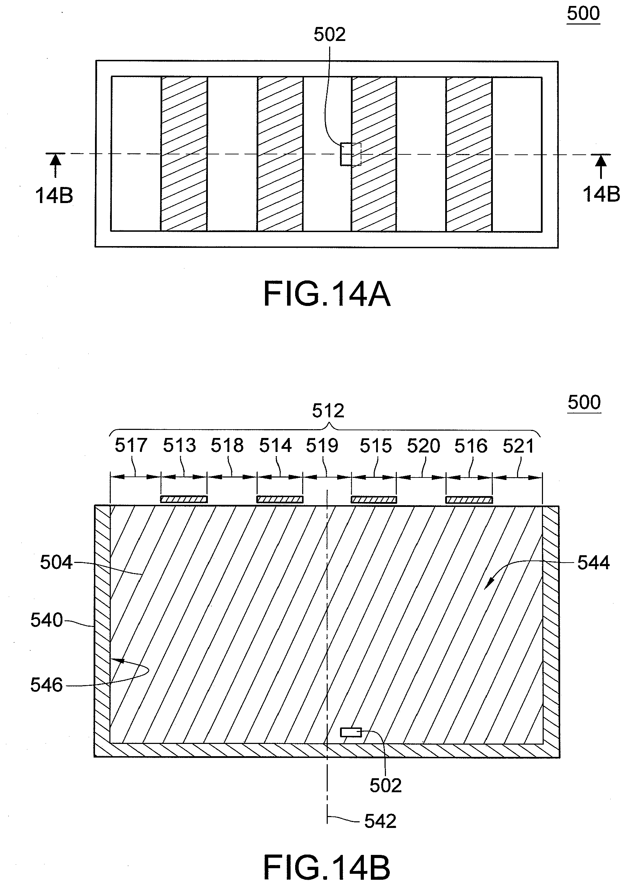

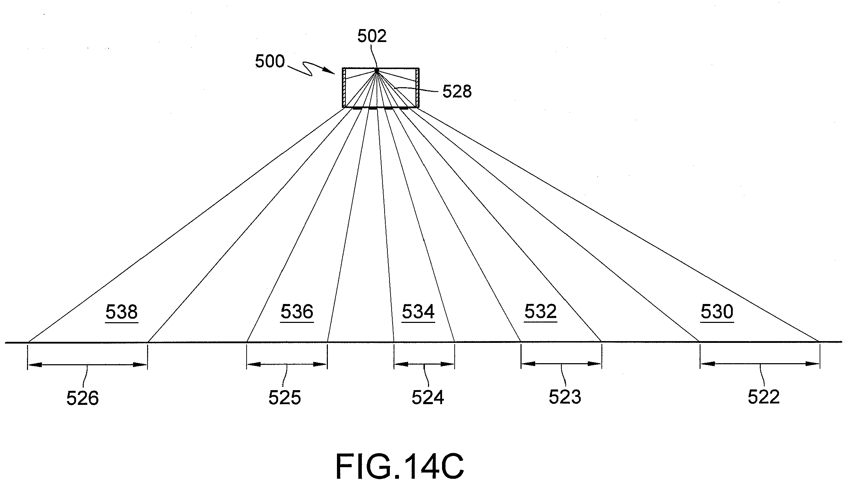

In the above embodiments, the optical element may be, but not limited to, the lens for description. However, the optical element of the LED packaging may also be a parallax barrier. For the detailed description, please refer to FIGs. 14A, 14B, and 14C.

FIG. 14A is a schematic top structural view of a sixth embodiment of an LED packaging structure, and FIG. 14B is a schematic cross-sectional structural view according to Line 14B-14B of FIG. 14A. Referring to FIGs. 14A and 14B, the LED packaging structure 500 comprises an LED die 502, a package body 504, and an optical element. The optical element is a parallax barrier 512, the parallax barrier 512 is disposed on the package body 504, and the package body 504 wraps the LED die 502.

FIG. 14C is a schematic view of light beam trace according to FIG. 14B. Referring to FIG. 14C, the parallax barrier 512 comprises a plurality of shield areas 513, 514, 515, and 516 and a plurality of exposure areas 517, 518, 519, 520, and 521, and the shield areas 513, 514, 515, and 516 and the exposure areas 517, 518, 519, 520, and 521 are alternately arranged. Each exposure area 517, 518, 519, 520, and 521 respectively has a image plane 522, 523, 524, 525, and 526 which corresponds to each exposure area 517, 518, 519, 520, and 521, and the image planes 522, 523, 524, 525, and 526 are spaced by a distance. The amount of the shield areas and the amount of the exposure areas are relevant to a relative position of the parallax barrier 512 and the package body 504, and may be adjusted according to actual demands. In this embodiment, the amount of the shield areas is four, the amount of the exposure areas is five, and the amount of the image planes is five, but this embodiment is not used to limit the present invention. It should be noted that the larger the amount of the exposure areas is, the larger the amount of the image planes is.

FIG. 14C is the schematic view of light beam trace according to FIG. 14B, so that each image plane 522, 523, 524, 525, and 526 is a line segment in FIG. 14C. In this embodiment, the image planes 522, 523, 524, 525, and 526 may be disposed on the same plane, but this embodiment is not used to limit the present invention.

When the LED die 502 emits a light beam 528, the light beam 528 emitted by the LED die 502 passes through the plurality of exposure areas 517, 518, 519, 520 and 521 and is split into a plurality of sub-light beams 530, 532, 534, 536, and 538, and the sub-light beams 530, 532, 534, 536, and 538 are projected onto the image planes 522, 523, 524, 525, and 526 which correspond to the sub-light beams 530, 532, 534, 536, and 538. The amount of the sub-light beams is the same as the amount of the exposure areas. In this embodiment, the package body 504 has a refraction index, and positions of the image planes 522, 523, 524, 525, and 526 are decided according to the refraction index of the package body 504 and the distributed positions of the exposure areas 517, 518, 519, 520 and 521. The refraction index of the package body 504 is affected by a wavelength of the light beam 528.

Referring to FIG. 14B, the LED packaging structure 500 further comprises a base 540, and the base 540 comprises a central axis 542 and an accommodation space 544. The LED die 502 is disposed in the accommodation space 544, and the LED die 502 may be disposed on a right side of the central axis 542, but this embodiment is not used to limit the present invention. That is to say, the LED die 502 may also be disposed on the central axis 542 or on a left side of the central axis 542. It should be noted that distribution of the positions of the image planes may be affected by a distance between the LED die and the central axis and a relative position of the LED die and the central axis. The part about above-mentioned is approximately the same as the situation when the optical element is the lens 106, and is not described in detail here.

The base 540 further comprises an inner side wall 546, the inner side wall 546 surrounds the accommodation space 544, and the light beam 528 incident to the inner side wall 546 is absorbed by the inner side wall 546, so as to prevent the inner side wall 546 from reflecting the light beam 528 to affect imaging quality of the LED packaging structure 500.

In the LED packaging structure according to the present invention, the amount of the image planes is controlled through the amount of the exposure areas, thereby achieving a multi-viewing angle objective. The positions of the image planes are controlled by the refraction index of the package body and the distributed positions of the exposure areas, wherein the refraction index of the package body is affected by the wavelength of the light beam. Next, the distribution of the positions of the image planes may also be affected by the distances between the LED die and the central axis and the relative positions of the LED die and the central axis. Further, the light beam incident to the inner side wall may be absorbed by the inner side wall, thereby ensuring the imaging quality of the LED packaging structure.

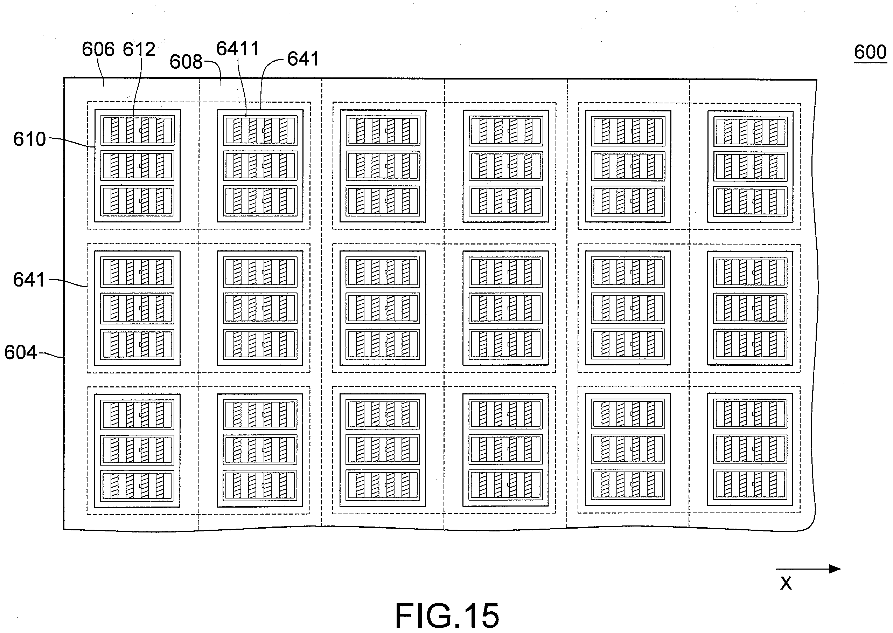

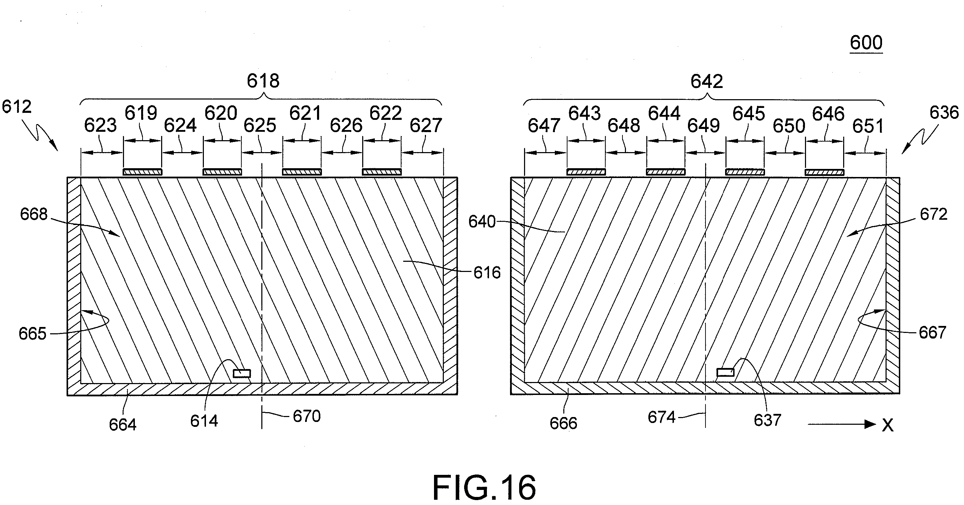

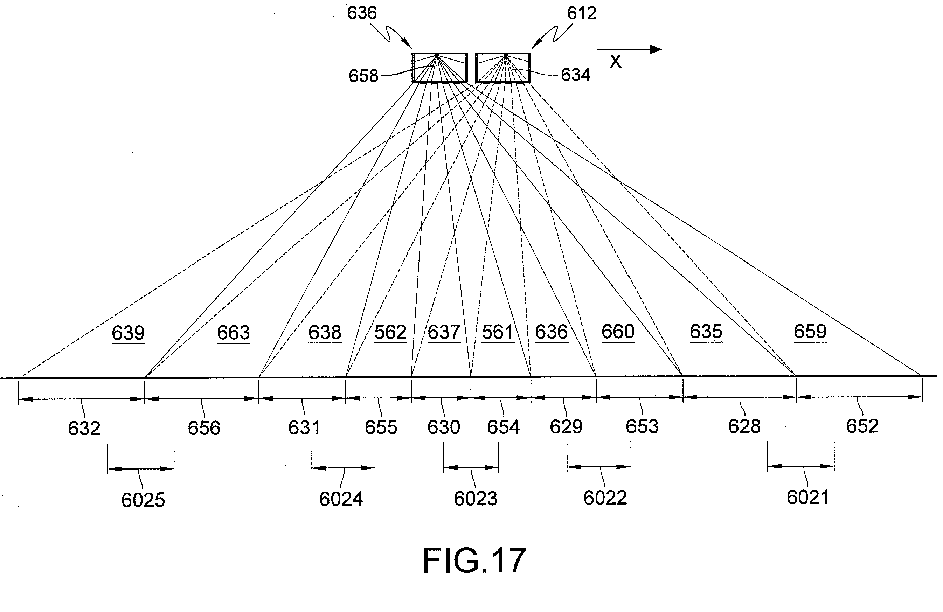

FIG. 15 is a schematic structural view of a second embodiment of an LED stereoscopic display device according to the present invention, FIG. 16 is a schematic cross-sectional structural view of a second LED packaging structure and a first LED packaging structure which corresponds to the second LED packaging structure according to FIG. 15, and FIG. 17 is a schematic view of light beam trace according to FIG. 16. Referring to FIGs. 15, 16, and 17, the LED stereoscopic display device 600 has a plurality of viewable areas 6021, 6022, 6023, 6024, and 6025 (referring to FIG. 17), and the viewable areas 6021, 6022, 6023, 6024, and 6025 are spaced by a distance. In this embodiment, the amount of the viewable areas is five, but this embodiment is not used to limit the present invention. The viewable area is an area where a viewer may view a stereoscopic image. FIG. 17 is the schematic view of light beam trace according to FIG. 16, so that each image plane 6021, 6022, 6023, 6024, and 6025 is a line segment in FIG. 16. In this embodiment, each image plane 6021, 6022, 6023, 6024, and 6025 may be disposed on the same plane, but this embodiment is not used to limit the present invention.

The LED stereoscopic display device 600 comprises a substrate 604, a plurality of first pixel areas 606, and a plurality of second pixel areas 608. The first pixel areas 606 and the second pixel areas 608 are alternately arranged along a direction X and are disposed on the substrate 604. The imaging of the first pixel area 606 is received by a right eye of the viewer, and the imaging of the second pixel area 608 is received by a left eye of the viewer, but this embodiment is not used to limit the present invention. Each first pixel area 606 comprises a plurality of first pixel units 610, each first pixel unit 610 comprises a plurality of first LED packaging structures 612, and the amount of the first pixel units 610 of each first pixel area 606 and the amount of the first LED packaging structures 612 of each first pixel unit 610 may be adjusted according to actual demands.

Each first LED packaging structure 612 comprises a first LED die 614 , a first package body 616, and an first optical element. The first optical element is a first parallax barrier 618, the first parallax barrier 618 is disposed on the first package body 616. The first package body 616 is used to wrap the first LED die 614. The first parallax barrier 618 comprises a plurality of first shield areas 619, 620, 621, and 622 and a plurality of first exposure areas 623, 624, 625, 626, and 627, and the first shield areas 619, 620, 621, and 622 and the first exposure areas 623, 624, 625, 626, and 627 are alternately arranged. Each first exposure area 623, 624, 625, 626, and 627 respectively has a first image plane 628, 629, 630, 631, and 632 which corresponds to each first exposure area 623, 624, 625, 626, and 627, and the first image planes 628, 629, 630, 631, and 632 are spaced by a distance. The amount of the shield areas and the amount of the exposure areas are relevant to a relative position of the first parallax barrier 618 and the package body 604, and may be adjusted according to the actual demands. In this embodiment, the amount of the first exposure areas is five, and the amount of the first image planes is five, but this embodiment is not used to limit the present invention.

The first LED die 602 emits a first light beam 634, the first light beam 634 passes through the first exposure areas 623, 624, 625, 626, and 627 and is split into first sub-light beams 635, 636, 637, 638, and 639, and the first sub-light beams 635, 636, 637, 638, and 639 are respectively projected onto the first image planes 628, 629, 630, 631, and 632. In this embodiment, each first image plane 628, 629, 630, 631, and 632 may be disposed on the same plane, but this embodiment is not used to limit the present invention.

Each second pixel area 608 comprises a plurality of second pixel units 641, each second pixel unit 641 comprises a plurality of second LED packaging structures 6411, and the amount of the second pixel units 641 of each second pixel area 608 and the amount of the second LED packaging structures 6411 of each second pixel unit 641 may be adjusted according to the actual demands. Each second pixel unit 641 corresponds to each first pixel unit 610, and each second LED packaging structure 6411 corresponds to each first LED packaging structure 612, wherein each second pixel unit 641 and each first pixel unit 610 which corresponds to each second pixel unit 641 form a pixel 641. Each second LED packaging structure 6411 comprises a second LED die 637 , a second package body 640, and an second optical element . The second optical element is a second parallax barrier 642, the second parallax barrier 642 is disposed on the package body 616. The second package body 640 is used to wrap the second LED die 637.

The second parallax barrier 642 comprises a plurality of second shield areas 643, 644, 645, and 646 and a plurality of second exposure areas 647, 648, 649, 650, and 651, and the second shield areas 643, 644, 645, and 646 and the second exposure areas 647, 648, 649, 650, and 651 are alternately arranged. Each second exposure area 647, 648, 649, 650, and 651 respectively has a second image plane 652, 653, 654, 655, and 656 which corresponds to Each second exposure area 647, 648, 649, 650, and 651, and the second image planes 652, 653, 654, 655, and 656 are spaced by a distance. The amount of the second exposure areas, the amount of the second image planes, and the amount of the viewable areas are the same. In this embodiment, the amount of the second exposure areas is five, and the amount of the second image planes is five, but this embodiment is not used to limit the present invention.

The second LED die 637 emits a second light beam 658, the second light beam 658 passes through the second exposure areas 647, 648, 649, 650, and 651 and is split into second sub-light beams 659, 660, 661, 662, and 663, and the second sub-light beams 659, 660, 661, 662, and 663 are respectively projected onto the second image planes 652, 653, 654, 655, and 656. In this embodiment, each second image plane 652, 653, 654, 655, and 656 may be disposed on the same plane, but this embodiment is not used to limit the present invention.

The amount of the second image planes is the same as the amount of the first image planes, and each second image plane 652, 653, 654, 655, and 656 corresponds to each first image plane 628, 629, 630, 631, and 632. An adjacent area of each second image plane and each first image plane which corresponds to each second image plane may respectively form a viewable area. That is to say, an adjacent area of the second image plane 652 and the first image plane 628 forms the viewable area 6021, an adjacent area of the second image plane 653 and the first image plane 629 forms the viewable area 6022, an adjacent area of the second image plane 654 and the first image plane 630 forms the viewable area 6023, an adjacent area of the second image plane 655 and the first image plane 631 forms the viewable area 6024, and an adjacent area of the second image plane 656 and the first image plane 632 forms the viewable area 6025.

In this embodiment, each first package body 616 has a first refraction index which is different from each other, each second package body 640 respectively has a second refraction index which is different from each other, each first exposure area 623, 624, 625, 626, and 627 and each second exposure area 647, 648, 649, 650, and 651 respectively have different distributions of positions, a position of each first image plane 628, 629, 630, 631, and 632 is decided according to the first refraction index and the distribution of the position of each first exposure area 623, 624, 625, 626, and 627, a position of each second image plane 652, 653, 654, 655, and 656 is decided according to the second refraction index and the distribution of the position of each second exposure area 647, 648, 649, 650, and 651, and a position of each viewable area 6021, 6022, 6023, 6024, and 6025 is decided according to the position of each first image plane 628, 629, 630, 631, and 632 and the position of each second image plane 652, 653, 654, 655, and 656 which is adjacent to each first image plane 628, 629, 630, 631, and 632. The first refraction index is affected by a wavelength of the first light beam 634, and the second refraction index is affected by a wavelength of the second light beam 658.

In this embodiment, each first pixel unit 610 comprises three first LED packaging structures 612, the three first LED packaging structures 612 respectively comprise a red LED die, a blue LED die, and a green LED die, the three first LED packaging structure 612 may be, but not limited to be, linearly arranged; each second pixel unit 641 comprises three second LED packaging structures 6411, the three second LED packaging structures 6411 respectively comprise a red LED die, a blue LED die, and a green LED die, the three second LED packaging structures 634 may be, but not limited to be, linearly arranged, but this embodiment is not used to limit the present invention, and adjustment may be performed according to actual demands.

Each first LED packaging structure 612 further comprises a first base 664, each second LED packaging structure 6411 further comprises a second base 666, each first base 664 comprises a first accommodation space 668 and a first central axis 670, each second base 666 comprises a second accommodation space 672 and a second central axis 674, the first LED die 614 is disposed in the first accommodation space 668, the second LED die 637 is disposed in the second accommodation space 672, the first LED die 614 may be disposed on a left side of the first central axis 670, and the second LED die 637 may be disposed on a right side of the second central axis 674, but this embodiment is not used to limit the present invention. It should be noted that a distance between the first LED die 614 and the first central axis 670 is changed according to a position of the first LED packaging structure 612 on the substrate 604, and a distance between the second LED die 637 and the second central axis 674 is changed according to a position of the second LED packaging structure 6411 on the substrate 604. The part about above-mentioned is similar to the situation when the optical element is the lens, and is not described in detail here.

Referring to FIG. 16, the first base 664 further comprises a first inner side wall 665, the first inner side wall 665 surrounds the first accommodation space 668, and the first light beam 634 incident to the first inner side wall 665 is absorbed by the first inner side wall 665, so as to prevent the first inner side wall 665 from reflecting the first light beam 634 to affect imaging quality of the first LED packaging structure 612. The second base 666 further comprises a second inner side wall 667, the second inner side wall 667 surrounds the second accommodation space 672, and the second light beam 658 incident to the second inner side wall 667 is absorbed by the second inner side wall 667, so as to prevent the second inner side wall 667 from reflecting the second light beam 658 to affect imaging quality of the second LED packaging structure 6411.

In the LED stereoscopic display device according to the present invention, the amount and the positions of the viewable areas may be controlled by the relative disposition and the design of the first LED packaging structures and the second LED packaging structures (that is, the amount and the distribution of the first exposure surfaces and the amount and the distribution of the second exposure surfaces, the refraction index of the first package body and the refraction index of the second package body), and the distance between the first LED die and the first central axis, the distance between the second LED die and the second central axis, the relative position of the first LED die and the first central axis, and the relative position of the second LED die and the second central axis are respectively changed according to the position of the first LED packaging structure and the position of the second LED packaging structure on the substrate, so that the LED stereoscopic display device has the plurality of viewable areas. Further, according to the design of the first inner side wall and the second inner side wall, the quality of the stereoscopic image shown by the LED stereoscopic display device may be improved.

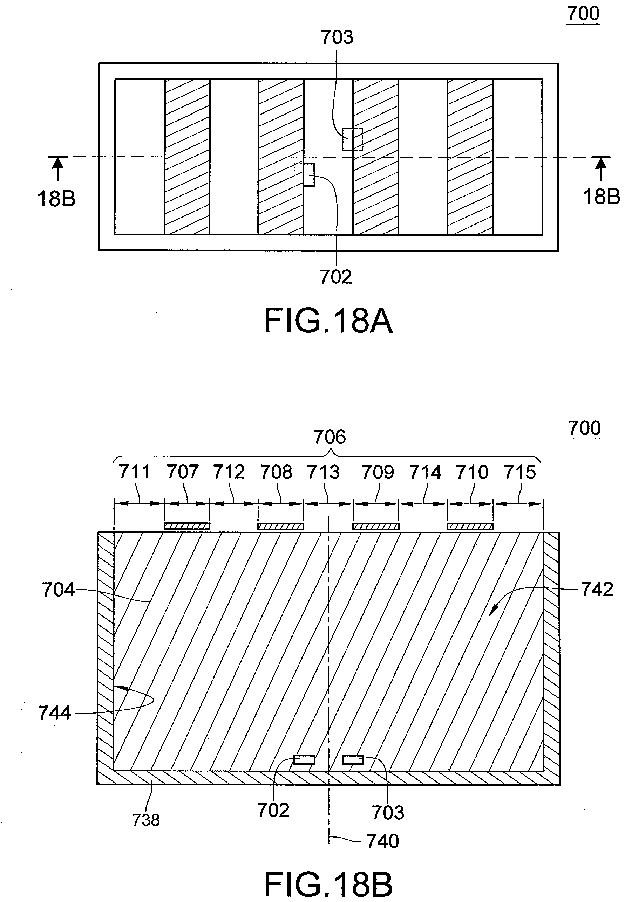

FIG. 18A is a schematic top structural view of a seventh embodiment of an LED packaging structure, and FIG. 18B is a schematic cross-sectional structural view according to Line 18B-18B of FIG. 18A. Referring to FIGs. 18A and 18B, the LED packaging structure 700 comprises a first LED die 702, a second LED die 703, a package body 704, and an optical element. In this embodiment, the optical element may be, but not limited to, a parallax barrier 706. The package body 704 wraps the first LED die 702 and the second LED die 703, and the parallax barrier 706 is disposed on the package body 704.

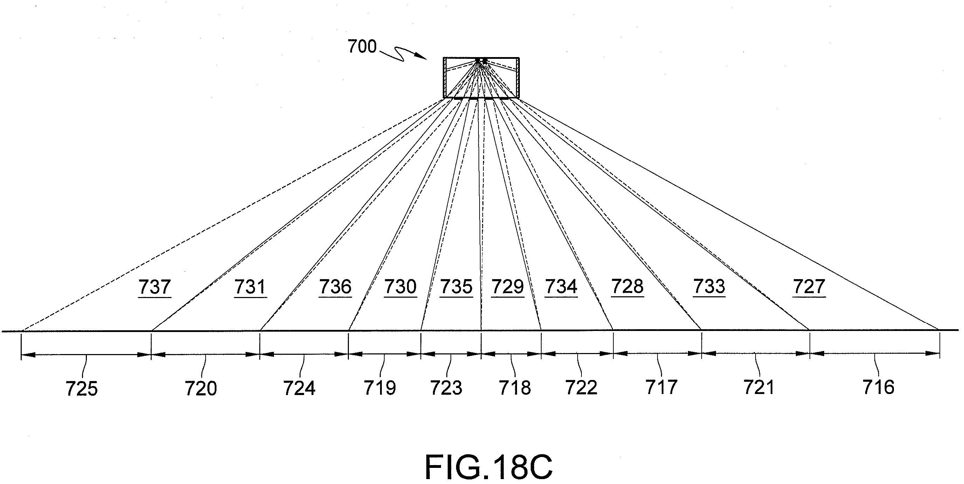

FIG. 18C is a schematic view of light beam trace according to FIG. 18B. Referring to FIG. 18C, the parallax barrier 706 comprises a plurality of shield areas 707, 708, 709, and 710 and a plurality of exposure areas 711, 712, 713, 714, and 715, and the shield areas 707, 708, 709, and 710 and the exposure areas 711, 712, 713, 714, and 715 are alternately arranged. Each exposure area 711, 712, 713, 714, and 715 respectively has a first image plane 716, 717, 718, 719, and 720 which corresponds to each exposure area 711, 712, 713, 714, and 715 and a second image plane 721, 722, 723, 724, and 725 which corresponds to each exposure area 711, 712, 713, 714, and 715. The amount of the shield areas and the amount of the exposure areas are relevant to a relative position of the parallax barrier 706 and the package body 704, and may be adjusted according to actual demands. In this embodiment, the amount of the exposure areas is five, the amount of the first image planes is five, and the amount of the second image planes is also five, but this embodiment is not used to limit the present invention. That is to say, when the amount of the exposure areas is six, the amount of the first image planes is six, and the amount of the second image planes is also six. More specifically, the larger the amount of the exposure areas is, the larger the amount of the first image planes and the second image planes are.

FIG. 18C is the schematic view of light beam trace according to FIG. 18B, so that each first image plane 716, 717, 718, 719, and 720 and each second image plane 721, 722, 723, 724, and 725 are a line segment in FIG. 18C. In this embodiment, each first image plane 716, 717, 718, 719, and 720 and each second image plane 721, 722, 723, 724, and 725 may be disposed on the same plane, but this embodiment is not used to limit the present invention.

The first LED die 702 emits a first light beam (as shown by a real line in package body 704), the first light beam (as shown by the real line in package body 704) emitted by the first LED die 702 passes through the plurality of exposure areas 711, 712, 713, 714, and 715 and is split into a plurality of first sub-light beams 727, 728, 729, 730, and 731, and the first sub-light beams 727, 728, 729, 730, and 731 are projected onto the first image planes 716, 717, 718, 719, and 720 which correspond to the first sub-light beams 727, 728, 729, 730, and 731. The amount of the first sub-light beams may be the same as the amount of the exposure areas. The second LED die 703 emits a second light beam (as shown by a dashed line in the package body 704), the second light beam (as shown by the dashed line in the package body 704) emitted by the second LED die 703 passes through the plurality of exposure areas 711, 712, 713, 714, and 715 and is split into a plurality of second sub-light beams 733, 734, 735, 736, and 737, and the second sub-light beams 733, 734, 735, 736, and 737 are projected onto the second image planes 721, 722, 723, 724, and 725 which correspond to the second sub-light beams 733, 734, 735, 736, and 737. The amount of the second sub-light beams is the same as the amount of the exposure areas.

In this embodiment, the package body 704 has a refraction index, and positions of the first image planes 716, 717, 718, 719, and 720 are decided according to the refraction index of the package body 704 and distribution of positions of the exposure areas 711, 712, 713, 714, and 715. Positions of the second image planes 721, 722, 723, 724, and 725 are decided according to the refraction index of the package body 704 and the distribution of the positions of the exposure areas 711, 712, 713, 714, and 715. The refraction of the package body 704 may be changed according to wavelengths of different light beams.

Referring to FIG. 18B, the LED packaging structure 700 further comprises a base 738, and the base 738 comprises a central axis 740 and an accommodation space 742. The first LED die 702 and the second LED die 703 are disposed in the accommodation space 742, the first LED die 702 may be disposed on a left side of the central axis 740, and the second LED die 703 may be disposed on a right side of the central axis 740, but this embodiment is not used to limit the present invention. It should be noted that distribution of positions of the first image planes 716, 717, 718, 719, and 720 may be affected by a distance between the first LED die 702 and the central axis 740 and a relative position of the first LED die 702 and the central axis 740, and distribution of positions of the second image planes 721, 722, 723, 724, and 725 may be affected by a distance between the second LED die 703 and the central axis 740 and a relative position of the second LED die 703 and the central axis 740. The part about above-mentioned is similar to the when the optical element is the lens, and is not described in detail here.

The first image planes 716, 717, 718, 719, and 720 correspond to the second image planes 721, 722, 723, 724, and 725, and the first image planes 716, 717, 718, 719, and 720 are disposed on one side of the second image planes 721, 722, 723, 724, and 725 which correspond to the first image planes 716, 717, 718, 719, and 720. That is to say, the first image planes 716, 717, 718, 719, and 720 and the second image planes 721, 722, 723, 724, and 725 are alternately arranged.

The base 738 further comprises an inner side wall 744, the inner side wall 744 surrounds the accommodation space 742, the first light beam (as shown by the real line in the package body 704) and the second light beam (as shown by the dashed line in the package body 704) incident to the inner side wall 744 are absorbed by the inner side wall 744, so as to prevent the inner side wall 744 from reflecting the first light beam and the second light beam to affect imaging quality of the LED packaging structure 700.

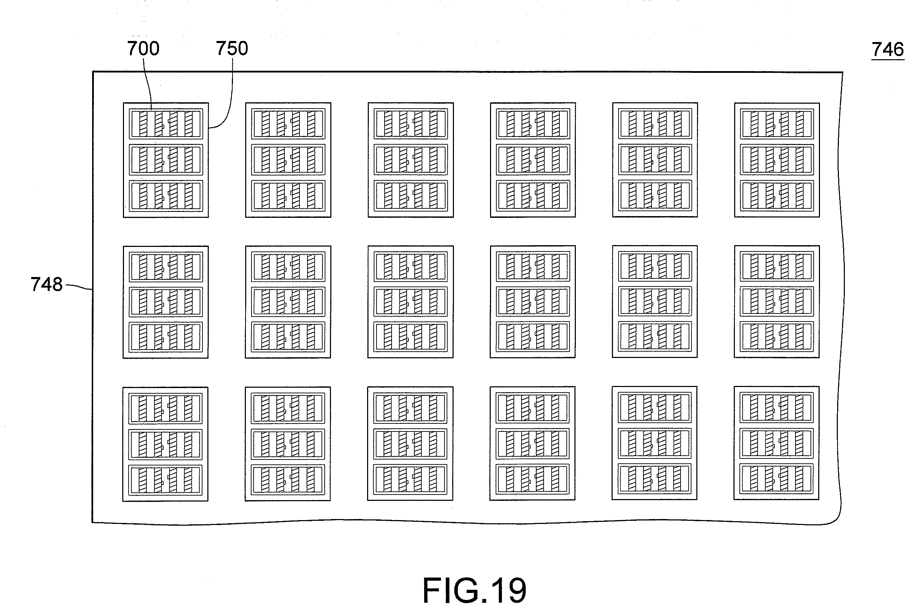

FIG. 19 is a schematic structural view of an embodiment in which the LED packaging structure according to FIG. 18B is applied to an LED stereoscopic display device which is not part of the invention. Referring to FIG. 19, the LED stereoscopic display device 746 comprises a substrate 748 and a plurality of pixel areas 750, each pixel area 750 is disposed on the substrate 748, each pixel area 750 may comprise, but not limited to, three LED packaging structures 700, and each pixel area 750 is a pixel. The three first LED dies 702 of each pixel area 750 may be, but not limited to, a red LED die, a green LED die, and a blue LED die, and the three first LED die 702 may be, but not limited to be, linearly arranged. The three second LED dies 703 of each pixel area 750 may be, but not limited to, a red LED die, a green LED die, and a blue LED die, and the three second LED dies 703 may be, but not limited to be, linearly arranged. In this embodiment, the LED stereoscopic display device 746 comprises five viewable areas, and each viewable area is formed by an adjacent area of each first image plane 716, 717, 718, 719, and 720 where each LED packaging structure 700 is projected and each second image plane 721, 722, 723, 724, and 725 which corresponds to each first image plane 716, 717, 718, 719, and 720.

In this embodiment, the distance between the first LED die 702 and the central axis 740 and the distance between the second LED die 703 and the central axis 740 are changed according to a position of the LED packaging structure 700 on the substrate 748. The part about above-mentioned is described in the above embodiment, and is not described in detail here.

In the LED packaging structure according to the present invention, the amount and the positions of the first image plane and the amount and the positions of the second image plane are controlled by the amount of the exposure areas and the relative disposition and the design of the first LED packaging structures and the second LED packaging structures (that is, the different refraction indices of the package body according to the different wavelengths of the first light beam and the second light beam, and the distribution of position of each exposure area), thereby achieving a multi-viewing angle objective, wherein each first image plane is adjacent to the second image plane which corresponds to each first image plane. Next, the distribution of the positions of the first image planes and the distribution of the positions of the second image planes may also be affected by the distance between the first LED die and the central axis and the distance between the second LED die and the central axis, the relative position of the first LED die and the central axis and the relative position of the second LED die and the central axis. Further, the light beams incident to the inner side wall may be absorbed by the inner side wall, so as to ensure the imaging quality of the LED packaging structure.

The LED packaging structure is applied to the LED stereoscopic display device, so that the LED stereoscopic display device comprises a plurality of viewable areas. Further, according to the design of the inner side wall, the quality of the stereoscopic image shown by the LED stereoscopic display device is ensured.

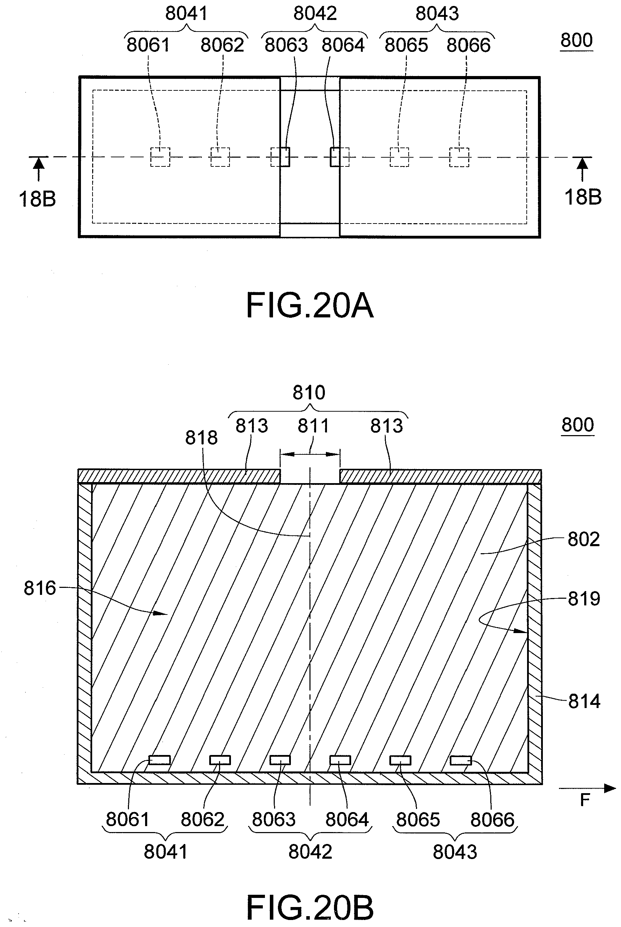

FIG. 20A is a schematic top structural view of a eighth embodiment of an LED packaging structure, and FIG. 20B is a schematic cross-sectional structural view according to Line 20B-20B of FIG. 20A. Referring to FIGs. 20A and 20B, the LED packaging structure 800 comprises a package body 802, a first light emitting unit 8041, a second light emitting unit 8042, a third light emitting unit 8043, and an optical element. In this embodiment, the optical element may be, but is not limited to, a parallax barrier 810. In this embodiment, the amount of the light emitting units is three, but this embodiment is not used to limit the present invention. The package body 802 is used to wrap the first light emitting unit 8041, the second light emitting unit 8042, and the third light emitting unit 8043, and the parallax barrier 810 is disposed on the package body 802.

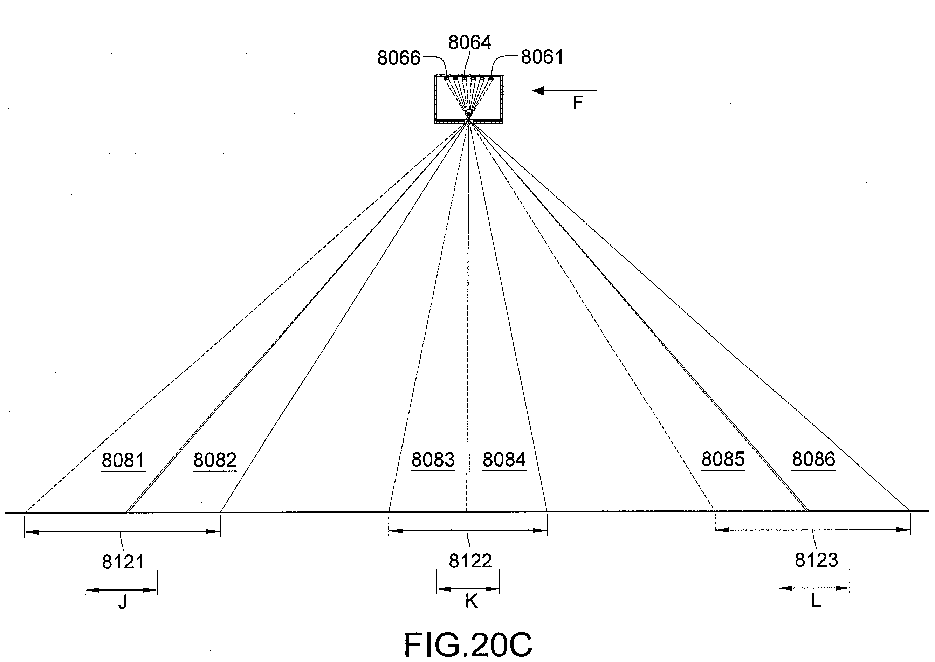

FIG. 20C is a schematic view of light beam trace according to FIG. 20B. Referring to FIG. 20C, the first light emitting unit 8041 comprises a first LED die 8061 and a second LED die 8062, the first LED die 8061 emits a first light beam 8081, and the second LED die 8062 emits a second light beam 8082. The second light emitting unit 8042 comprises a first LED die 8063 and a second LED die 8064, the first LED die 8063 emits a first light beam 8083, and the second LED die 8064 emits a second light beam 8084. The third light emitting unit 8043 comprises a first LED die 8065 and a second LED die 8066, the first LED die 8065 emits a first light beam 8085, and the second LED die 8066 emits a second light beam 8086. The first light emitting unit 8041, the light emitting unit 8042, and the light emitting unit 8043 are arranged in sequence along a direction F. More specifically, the sequence of arrangement along the direction F is the first LED die 8061, the second LED die 8062, the first LED die 8063, the second LED die 8064, the first LED die 8065, and the second LED die 8066, but this embodiment is not used to limit the present invention.

The parallax barrier 810 comprises an exposure area 811 and two shield areas 813, the first light beam 8081 and the second light beam 8082 respectively pass through the exposure area 811 and are respectively projected onto an image plane 8121, and a position of the first light beam 8081 projected onto the image plane 8121 is disposed on one side of a position of the second light beam 8082 projected onto the image plane 8121. The first light beam 8083 and the second light beam 8084 respectively pass through the exposure area 811 and are respectively projected onto an image plane 8122, a position of the first light beam 8083 projected onto the image plane 8122 is disposed on one side of a position of the second light beam 8084 projected onto the image plane 8122. The first light beam 8085 and the second light beam 8086 respectively pass through the exposure area 811 and are respectively projected onto an image plane 8123, and a position of the first light beam 8085 projected onto the image plane 8123 is disposed on one side of the second light beam 8086 projected onto the image plane 8123.

FIG. 20C is the schematic view of light beam trace according to FIG. 20B, so that each image plane 8121, 8122, and 8123 is a line segment in FIG. 20C. In this embodiment, each image plane 8121, 8122, and 8123 may be disposed on the same plane, but this embodiment is not used to limit the present invention.

Referring to FIG. 20B, the LED packaging structure 800 further comprises a base 814, the base 814 comprises an accommodation space 816 and a central axis 818, the light emitting unit 8041, the light emitting unit 8042, and the light emitting unit 8043 are disposed in the accommodation space 816, the central axis 818 may be disposed in the middle of the first LED die 8063 and the second LED die 8064, so that the amount of the LED dies on two sides of the central axis 818 is the same (that is to say, the first LED die 8061, the second LED die 8062, and the first LED die 8063 are on a left side of the central axis 818, and the second LED die 8064, the first LED die 8065, and the second LED die 8066 are on a right side of the central axis 418), but this embodiment is not used to limit the present invention.

The base 814 further comprises an inner side wall 819, the inner side wall 819 surrounds the accommodation space 816, and the light beams (that is, the first light beams 8081, 8083, and 8085 and the second light beams 8082, 8084, and 8086) incident to the inner side wall 819 are absorbed by the inner side wall 819, so as to prevent the inner side wall 819 from reflecting the light beams (that is, the first light beams 8081, 8083, and 8085 and the second light beams 8082, 8084, and 8086) to affect imaging quality of the LED packaging structure 800.

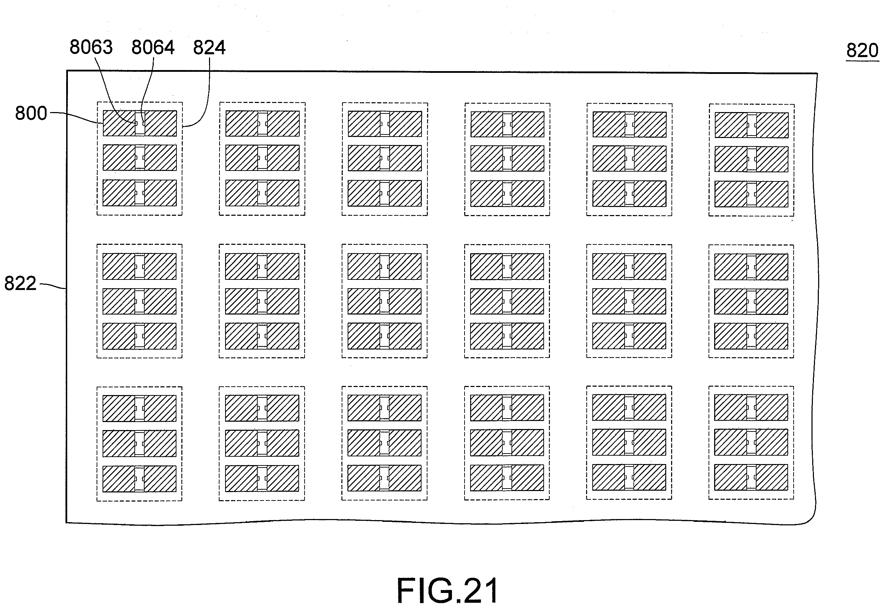

FIG. 21 is a schematic structural view of an embodiment in which the LED packaging structure according to FIG. 20B is applied to an LED stereoscopic display device which is not part of the invention. Referring to FIG. 21, the LED stereoscopic display device 820 comprises a substrate 822 and a plurality of LED packaging structures 800, and each LED packaging structure 800 is disposed on the substrate 822. The LED stereoscopic display device 820 further comprises a plurality of pixel areas 824, each pixel area 824 may comprise, but not limited to, three LED packaging structures 800, and the three LED packaging structures 800 may be, but not limited to be, linearly arranged. At least three first light emitting units 8041, three second light emitting units 8042, or three third light emitting units 8043 form a pixel (not shown). For example, when each pixel is formed by three first light emitting units 8041, the three first LED dies 8061 comprise a red LED die, a green LED die, and a blue LED die. In this embodiment, each pixel area 824 comprises three LED packaging structures 800, and the three LED packaging structures 800 may be, but not limited to be, linearly arranged. The three first LED dies 8061 comprise a red LED die, a green LED die, and a blue LED die, but this embodiment is not used to limit the present invention.

The LED stereoscopic display device 820 has a plurality of viewable areas, taking this embodiment as an example, the LED stereoscopic display device 820 according to this embodiment has three viewable areas J, K, and L, the viewable area J is an adjacent area of the position of the first light beam 8081 projected onto the image plane 8121 and the position of the second light beam 8082 projected onto the image plane 8121, the viewable area K is an adjacent area of the position of the first light beam 8083 projected onto the image plane 8122 and the position of the second light beam 8084 projected onto the image plane 8122, and the viewable area L is an adjacent area of the position of the first light beam 8085 projected onto the image plane 8123 and the position of the second light beam 8086 projected onto the image plane 8123, but this embodiment is not used to limit the present invention.

Therefore, in the LED packaging structure, the amount of the image planes may be adjusted by controlling the amount of the light emitting units. The positions of the image planes may be adjusted by the refraction index of the package body and the design of the exposure surface, so that the image planes are not overlapped to generate interference. Next, the LED packaging structure is applied to the LED stereoscopic display device, so that the viewer may view different stereoscopic image at different viewable areas, and the different stereoscopic images doe not interfere with each other. The LED stereoscopic display device according to the present invention is formed by the plurality of LED packaging structures, and each LED packaging structure may be designed and adjusted according to actual demands, thereby eliminating the problems of the conventional LED stereoscopic display device that the manufacturing process is difficult, and the quality of the image is changed when a distance between eyes of the viewer and the LED stereoscopic display device is changed.

The invention is defined by the appended claims.

## Claims

1. A Light Emitting Diode (LED) stereoscopic display device, having a plurality of viewable areas (2021, 2022, 2023, 2024, and 2025), the LED stereoscopic display device (200) comprising:
a substrate (204);
a plurality of first pixel areas (206), disposed on the substrate (204), and each of the plurality of first pixel areas (206) comprising a plurality of first pixel units (210), wherein each of the plurality of first pixel units (210) comprises a plurality of first LED packaging structures (212), and each of the plurality of first LED packaging structures (212) comprises:
a first LED die (214), for emitting a first light beam (224);
a first package body (216), for wrapping the first LED die (214);
a first base (246), comprising a first accommodation space (250) and a first central axis (252), the first LED die (214) disposed in the first accommodation space (250) and not located on the first central axis (252);
a first optical element, disposed on the first package body (216), wherein the first light beam (224) passes through the first optical element and is split into a plurality of first sub-light beams (2261, 2262, 2263, 2264, and 2265), and each of the plurality of first sub-light beams (2261, 2262, 2263, 2264, or 2265) is individually projected onto a first image plane (2221, 2222, 2223, 2224, and 2225) which corresponds to each of the plurality of first sub-light beams (2261, 2262, 2263, 2264, or 2265); and
a plurality of second pixel areas (208), alternately arranged together with the first pixel area (206) along a direction (P) and disposed on the substrate (204), and each of the plurality of second pixel areas (208) comprising a plurality of second pixel units (228), wherein each of the plurality of second pixel units (228) comprises a plurality of second LED packaging structures (230), each of the plurality of second LED packaging structures (230) corresponds to each first LED packaging structures (212), and each of the plurality of second LED packaging structures (230) comprises:
a second LED die (232), for emitting a second light beam (242);
a second package body (234), for wrapping the second LED die (232);
a second base (248), comprising a second accommodation space (254) and a second central axis (256), the second LED die (232) disposed in the second accommodation space (254) and not located on the second central axis (256);
a second optical element, disposed on the second package body (234), wherein the second light beam (242) passes through the second optical element and is split into a plurality of second sub-light beams (2441, 2442, 2443, 2444, and 2445), each of the plurality of second sub-light beams (2441, 2442, 2443, 2444, or 2445) is individually projected onto a second image plane (2401, 2402, 2403, 2404, or 2405) which corresponds to each of the plurality of second sub-light beams (2441, 2442, 2443, 2444, or 2445), each second image plane (2401, 2402, 2403, 2404, or 2405) corresponds to each first image plane (2221, 2222, 2223, 2224, or 2225), and an adjacent area of each second image plane (2401, 2402, 2403, 2404, or 2405) and each first image plane (2221, 2222, 2223, 2224, or 2225) which corresponds to each second image plane (2401, 2402, 2403, 2404, or 2405) forms the viewable area (2021, 2022, 2023, 2024, or 2025).

2. The LED stereoscopic display device according to claim 1, wherein a distance between each the first LED die (214) and each the first central axis (252) is changed according to a position of each the first LED packaging structure (212) on the substrate (204), and a distance between each the second LED die (232) and each the second central axis (256) is changed according to a position of each the second LED packaging structure (230) on the substrate (204).

3. The LED stereoscopic display device according to claim 1, wherein each the first optical element is a first lens (218), each the first lens (218) comprises a plurality of first curved surfaces (2201, 2202, 2203, 2204, and 2205), each the second optical element is a second lens (236), each the second lens (236) comprises a plurality of second curved surfaces (2381, 2382, 2383, 2384, and 2385), each first curved surface (2201, 2202, 2203, 2204, or 2205) has the first image plane (2221, 2222, 2223, 2224, or 2225) which corresponds to each first curved surface (2201, 2202, 2203, 2204, or 2205), each second curved surface (2381, 2382, 2383, 2384, or 2385) has the second image plane (2401, 2402, 2403, 2404, or 2405) which corresponds to each second curved surface (2381, 2382, 2383, 2384, or 2385), the first sub-light beams (2261, 2262, 2263, 2264, and 2265) respectively pass through each first curved surface (2201, 2202, 2203, 2204, or 2205) and are projected onto the first image planes (2221, 2222, 2223, 2224, and 2225) which correspond to the first sub-light beams (2261, 2262, 2263, 2264, and 2265), and the second sub-light beams (2441, 2442, 2443, 2444, and 2445) respectively pass through each second curved surface (2381, 2382, 2383, 2384, or 2385) and are projected onto the second image planes (2401, 2402, 2403, 2404, and 2405) which correspond to the second sub-light beams (2441, 2442, 2443, 2444, and 2445).

4. The LED stereoscopic display device according to claim 1, wherein each the first optical element is a first parallax barrier (618), each the first parallax barrier (618) comprises a plurality of first exposure areas (623, 624, 625, 626, and 627), each the second optical element is a second parallax barrier (642), each the second parallax barrier (642) comprises a plurality of second exposure areas (647, 648, 649, 650, and 651), each of the plurality of first exposure areas (623, 624, 625, 626, or 627) respectively has the first image plane (628, 629, 630, 631, or 632) which corresponds to each of the plurality of first exposure areas (623, 624, 625, 626, or 627), each of the plurality of second exposure areas (647, 648, 649, 650, or 651) respectively has the second image plane (652, 653, 654, 655, or 656) which corresponds to each of the plurality of second exposure areas (647, 648, 649, 650, or 651), the plurality of first sub-light beams (635, 636, 637, 638, and 639) respectively passes through each of the plurality of first exposure areas (623, 624, 625, 626, or 627) and is projected onto the first image planes (628, 629, 630, 631, and 632) which correspond to the plurality of first exposure areas (623, 624, 625, 626, and 627), and the second sub-light beams (659, 660, 661, 662, and 663) respectively pass through each of the plurality of second exposure areas (647, 648, 649, 650, or 651) and are projected onto the second image planes (652, 653, 654, 655, and 656) which correspond to of the plurality of second exposure areas (647, 648, 649, 650, and 651).

5. The LED stereoscopic display device according to claim 1, wherein each first pixel unit (210) comprises at least three first LED packaging structures (212), and each of the plurality of first LED packaging structures (212) respectively comprises at least one red LED die, at least one blue LED die, and at least one green LED die; and each second pixel unit (228) comprises at least three second LED packaging structures (230), and each of the plurality of second LED packaging structures (230) respectively comprises at least one red LED die, at least one blue LED die, and at least one green LED die.

6. The LED stereoscopic display device according to claim 5, wherein the first LED packaging structures (212) are linearly arranged, and the second LED packaging structures (230) are linearly arranged.

7. The LED stereoscopic display device according to claim 1, wherein the substrate (204) comprises a first area (82), a second area (84), and a third area (86), a first included angle (X₁) is formed between the first area (82) and the second area (84), a second included angle (X₂) is formed between the second area (84) and the third area (86), the first area (82) comprises a first central axis (90), the second area (84) comprises a second central axis (92), the third area (86) comprises a third central axis (94), the first included angle and the second included angle enable the first central axis (90), the second central axis (92), and the third central axis (94) to intersect at one point.

## Patentansprüche

1. Stereoskopische Anzeigevorrichtung mit lichtemittierender Diode (LED) (stereoskopische LED-Anzeige-Vorrichtung), welche eine Mehrzahl von sichtbaren Bereichen (2021, 2022, 2023, 2024 und 2025) hat, wobei die stereoskopische LED-Anzeige-Vorrichtung (200) aufweist:
ein Substrat (204),
eine Mehrzahl von ersten Pixelbereichen (206), welche auf dem Substrat (204) angeordnet sind, wobei jeder von der Mehrzahl von ersten Pixelbereichen (206) eine Mehrzahl von ersten LED-Packaging-Strukturen (212) aufweist, und wobei jede von der Mehrzahl von ersten LED-Packaging-Strukturen (212) aufweist:
einen ersten LED-Die (214) zum Emittieren eines ersten Lichtstrahls (224),
einen ersten Package-Körper (216) zum Einhüllen des ersten LED-Dies (214),
eine erste Basis (246), welcher einen ersten Unterbringungsraum (250) und eine erste zentrale Achse (252) aufweist, wobei der erste LED-Die (214) in dem ersten Unterbringungsraum (250) angeordnet ist und sich nicht auf der ersten zentralen Achse (252) befindet,
ein erstes optisches Element, welches auf dem ersten Package-Körper (216) angeordnet ist, wobei der erste Lichtstrahl (224) durch das erste optische Element hindurchgeht und in eine Mehrzahl von ersten Sub-Lichtstrahlen (2261, 2262, 2263, 2264 und 2265) aufgeteilt wird, und wobei jeder von der Mehrzahl von ersten Sub-Lichtstrahlen (2261, 2262, 2263, 2264 oder 2265) individuell auf eine erste Bildebene (2221, 2222, 2223, 2224 und 2225) projiziert wird, welche mit jedem von der Mehrzahl von ersten Sub-Lichtstrahlen (2261, 2262, 2263, 2264 oder 2265) korrespondiert, und
eine Mehrzahl von zweiten Pixelbereichen (208), welche gemeinsam mit dem ersten Pixelbereich (206) entlang einer Richtung (P) abwechselnd angeordnet sind und auf dem Substrat (204) angeordnet sind, und wobei jeder von der Mehrzahl von zweiten Pixelbereichen (208) eine Mehrzahl von zweiten Pixeleinheiten (228) aufweist, wobei jede von der Mehrzahl von zweiten Pixeleinheiten (228) eine Mehrzahl von zweiten LED-Packaging-Strukturen (230) aufweist, wobei jede von der Mehrzahl von zweiten LED-Packaging-Strukturen (230) mit jeder von den ersten LED-Packaging-Strukturen (212) korrespondiert, und wobei jede von der Mehrzahl von zweiten LED-Packaging-Strukturen (230) aufweist:
einen zweiten LED-Die (232) zum Emittieren eines zweiten Lichtstrahls (242),
einen zweiten Package-Körper (234) zum Einhüllen des zweiten LED-Dies (232),
eine zweite Basis (248), welcher einen zweiten Unterbringungsraum (254) und eine zweite zentrale Achse (256) aufweist, wobei der zweite LED-Die (232) in dem zweiten Unterbringungsraum (254) angeordnet ist und sich nicht auf der zweiten zentralen Achse (256) befindet,
ein zweites optisches Element, welches auf dem zweiten Package-Körper (234) angeordnet ist, wobei der zweite Lichtstrahl (242) durch das zweite optische Element hindurchgeht und in eine Mehrzahl von zweiten Sub-Lichtstrahlen (2441, 2442, 2443, 2444 und 2445) aufgeteilt wird, wobei jeder von der Mehrzahl von zweiten Sub-Lichtstrahlen (2441, 2442, 2443, 2444 oder 2445) individuell auf eine zweite Bildebene (2401, 2402, 2403, 2404 oder 2405) projiziert wird, welche mit jedem von der Mehrzahl von zweiten Sub-Lichtstrahlen (2441, 2442, 2443, 2444 oder 2445) korrespondiert, wobei jede zweite Bildebene (2401, 2402, 2403, 2404 oder 2405) mit jeder ersten Bildebene (2221, 2222, 2223, 2224 oder 2225) korrespondiert, und wobei ein benachbarter Bereich jeder zweiten Bildebene (2401, 2402, 2403, 2404 oder 2405) und jeder ersten Bildebene (2221, 2222, 2223, 2224 oder 2225), welche mit jeweils der zweiten Bildebene (2401, 2402, 2403, 2404 oder 2405) korrespondiert, den sichtbaren Bereich (2021, 2022, 2023, 2024 oder 2025) bildet.

2. Stereoskopische LED-Anzeige-Vorrichtung gemäß Anspruch 1, wobei ein Abstand zwischen jedem ersten LED-Die (214) und jeder ersten zentralen Achse (252) verändert wird entsprechend einer Position jeder ersten LED-Packaging-Struktur (212) auf dem Substrat (204), und wobei ein Abstand zwischen jedem zweiten LED-Die (232) und jeder zweiten zentralen Achse (256) verändert wird entsprechend einer Position jeder zweiten LED-Packaging-Struktur (230) auf dem Substrat (204).

3. Stereoskopische LED-Anzeige-Vorrichtung gemäß Anspruch 1, wobei jedes erstes optische Element eine erste Linse (218) ist, wobei die erste Linse (218) eine Mehrzahl von ersten gekrümmten Flächen (2201, 2202, 2203, 2204 und 2205) aufweist, und wobei jedes zweite optische Element eine zweite Linse (236) ist, wobei die zweite Linse (236) eine Mehrzahl von zweiten gekrümmten Flächen (2381, 2382, 2383, 2384 und 2385) aufweist, wobei jede erste gekrümmte Fläche (2201, 2202, 2203, 2204 oder 2205) die erste Bildebene (2221, 2222, 2223, 2224 oder 2225) zugeordnet hat, welche mit jeder ersten gekrümmten Flächen (2201, 2202, 2203, 2204 oder 2205) korrespondieren, und wobei jede zweite gekrümmte Fläche (2381, 2382, 2383, 2384 oder 2385) die zweite Bildebene (2401, 2402, 2403, 2404 oder 2405)zugeordnet hat, welche mit jeder zweiten gekrümmten Fläche (2381, 2382, 2383, 2384 oder 2385) korrespondiert, wobei die ersten Sub-Lichtstrahlen (2261, 2262, 2263, 2264 und 2265) jeweils durch jede erste gekrümmte Fläche (2201, 2202, 2203, 2204 oder 2205) hindurchgehen und auf die ersten Bildebenen (2221, 2222, 2223, 2224 und 2225) projiziert werden, welche mit den ersten Sub-Lichtstrahlen (2261, 2262, 2263, 2264 und 2265) korrespondieren, und wobei die zweiten Sub-Lichtstrahlen (2441, 2442, 2443, 2444 und 2445) jeweils durch jede zweite gekrümmte Fläche (2381, 2382, 2383, 2384 oder 2385) hindurchgehen und auf die zweiten Bildebenen (2401, 2402, 2403, 2404 und 2405) projiziert werden, welche mit den zweiten Sub-Lichtstrahlen (2441, 2442, 2443, 2444 und 2445) korrespondieren.

4. Stereoskopische LED-Anzeige-Vorrichtung gemäß Anspruch 1, wobei jedes erste optische Element eine erste Parallaxenbarriere (618) ist, wobei jede erste Parallaxenbarriere (618) eine Mehrzahl von ersten Belichtungsbereichen (623, 624, 625, 626 und 627) aufweist, wobei jedes zweite optische Element eine zweite Parallaxenbarriere (642) ist, wobei jede zweite Parallaxenbarriere (642) eine Mehrzahl von zweiten Belichtungsbereichen (647, 648, 649, 650 und 651) aufweist, wobei jeder von der Mehrzahl von den ersten Belichtungsbereichen (623, 624, 625, 626 oder 627) jeweils die erste Bildebene (628, 629, 630, 631 oder 632) zugeordnet hat, welche mit jedem von der Mehrzahl von den ersten Belichtungsbereichen (623, 624, 625, 626 oder 627) korrespondiert, wobei jeder von der Mehrzahl von den zweiten Belichtungsbereichen (647, 648, 649, 650 oder 651) jeweils die zweite Bildebene (652, 653, 654, 655 oder 656) zugeordnet hat, welche mit jedem von der Mehrzahl von zweiten Belichtungsbereichen (647, 648, 649, 650 oder 651) korrespondiert, wobei die Mehrzahl von ersten Sub-Lichtstrahlen (635, 636, 637, 638 und 639) jeweils durch jeden von der Mehrzahl von ersten Belichtungsbereichen (623, 624, 625, 626 oder 627) hindurchgeht und auf die ersten Bildebenen (628, 629, 630, 631 und 632) projiziert wird, welche mit der Mehrzahl von ersten Belichtungsbereichen (623, 624, 625, 626 und 627) korrespondieren, und wobei die zweiten Sub-Lichtstrahlen (659, 660, 661, 662 und 663) jeweils durch jeden von der Mehrzahl von zweiten Belichtungsbereichen (647, 648, 649, 650 oder 651) hindurchgehen und auf die zweiten Bildebenen (652, 653, 654, 655 und 656) projiziert werden, welche mit der Mehrzahl von zweiten Belichtungsbereichen (647, 648, 649, 650 und 651) korrespondieren.

5. Stereoskopische LED-Anzeige-Vorrichtung gemäß Anspruch 1, wobei jede erste Pixeleinheit (210) zumindest drei erste LED-Packaging-Strukturen (212) aufweist, und wobei jede von der Mehrzahl von ersten LED-Packaging-Strukturen (212) jeweils zumindest einen rote LED-Die, zumindest einen blauen LED-Die und zumindest einen grünen LED-Die aufweist, und wobei jede zweite Pixeleinheit (228) zumindest drei zweite LED-Packaging-Strukturen (230) aufweist, und wobei jede von der Mehrzahl von zweiten LED-Packaging-Strukturen (230) jeweils zumindest einen rote LED-Die, zumindest einen blauen LED-Die und zumindest einen grünen LED-Die aufweist.

6. Stereoskopische LED-Anzeige-Vorrichtung gemäß Anspruch 5, wobei die ersten LED-Packaging-Strukturen (212) linear angeordnet sind und die zweiten LED-Packaging-Strukturen (230) linear angeordnet sind.

7. Stereoskopische LED-Anzeige-Vorrichtung gemäß Anspruch 1, wobei das Substrat (204) einen ersten Bereich (82), einen zweiten Bereich (84) und einen dritten Bereich (86) aufweist, wobei ein erster eingeschlossener Winkel (X₁) zwischen dem ersten Bereich (82) und den zweiten Bereich (84) gebildet ist, wobei ein zweiter eingeschlossene Winkel (X₂) zwischen dem zweiten Bereich (84) und dem dritten Bereich (86) gebildet ist, wobei der erste Bereich (82) eine erste zentrale Achse (90) aufweist, der zweite Bereich (80) eine zweite zentrale Achse (92) aufweist, und der dritte Bereich (86) eine dritte zentrale Achse (94) aufweist, wobei der erste eingeschlossene Winkel und der zweite eingeschlossene Winkel es der ersten zentrale Achse (90), der zweiten zentralen Achse (92) und der dritten zentralen Achse (94) ermöglichen, sich in einem Punkt zu schneiden.

## Revendications

1. Dispositif d'affichage stéréoscopique à diodes électroluminescentes (LED), présentant une pluralité de zones visualisables (2021, 2022, 2023, 2024, et 2025), le dispositif d'affichage stéréoscopique à LED (200) comprenant :
un substrat (204) ;
une pluralité de premières zones de pixels (206), disposées sur le substrat (204), et chacune de la pluralité de premières zones de pixels (206) comprend une pluralité de premières unités de pixels (210), où chacune de la pluralité de premières unités de pixels (210) comprend une pluralité de premières structures de boîtiers de LED (212), et chacune de la pluralité de premières structures de boîtiers de LED (212) comprend :
une première puce de LED (214), destinée à émettre un premier faisceau de lumière (224) ;
un premier corps de boîtier (216), destiné à envelopper la première puce de LED (214) ;
une première base (246), comprenant un premier espace de réception (250) et un premier axe central (252), la première puce de LED (214) étant disposée dans le premier espace de réception (250) et n'étant pas située sur le premier axe central (252) ;
un premier élément optique, disposé sur le premier corps de boîtier (216), où le premier faisceau de lumière (224) passe à travers le premier élément optique, et est scindé en une pluralité de premiers faisceaux de lumière secondaire (2261, 2262, 2263, 2264, et 2265), et chacun de la pluralité de premiers faisceaux de lumière secondaire (2261, 2262, 2263, 2264, ou 2265) est projeté individuellement sur un premier plan d'image (2221, 2222, 2223, 2224, et 2225) qui correspond à chacun de la pluralité de premiers faisceaux de lumière secondaire (2261, 2262, 2263, 2264, ou 2265) ; et
une pluralité de secondes zones de pixels (208), agencées de manière alternée avec les premières zones de pixels (206) le long d'une direction (P), et disposées sur le substrat (204), et chacune de la pluralité de secondes zones de pixels (208) comprend une pluralité de secondes unités de pixels (228), où chacune de la pluralité de secondes unités de pixels (228) comprend une pluralité de secondes structures de boîtiers de LED (230), chacune de la pluralité de secondes structures de boîtiers de LED (230) correspond à chacune des premières structures de boîtiers de LED (212), et chacune de la pluralité de secondes structures de boîtiers de LED (230) comprend :
une seconde puce de LED (232), destinée à émettre un second faisceau de lumière (242) ;
un second corps de boîtier (234), destiné à envelopper la seconde puce de LED (232) ;
une seconde base (248), comprenant un second espace de réception (254) et un second axe central (256), la seconde puce de LED (232) étant disposée dans le second espace de réception (254) et n'étant pas située sur le second axe central (256) ;
un second optique élément, disposé sur le second corps de boîtier (234), où le second faisceau de lumière (242) passe à travers le second élément optique, et est scindé en une pluralité de seconds faisceaux de lumière secondaire (2441, 2442, 2443, 2444, et 2445), chacun de pluralité de seconds faisceaux de lumière secondaire (2441, 2442, 2443, 2444, ou 2445) est projeté individuellement sur un second plan d'image (2401, 2402, 2403, 2404, ou 2405) qui correspond à chacun de la pluralité de seconds faisceaux de lumière secondaire (2441, 2442, 2443, 2444, ou 2445), chaque second plan d'image (2401, 2402, 2403, 2404, ou 2405) correspond à chaque premier plan d'image (2221, 2222, 2223, 2224, ou 2225), et à une zone adjacente de chaque second plan d'image (2401, 2402, 2403, 2404, ou 2405), et chaque premier plan d'image (2221, 2222, 2223, 2224, ou 2225) qui correspond à chaque second plan d'image (2401, 2402, 2403, 2404, ou 2405), forme la zone visualisable (2021, 2022, 2023, 2024, ou 2025).

2. Dispositif d'affichage stéréoscopique à LED selon la revendication 1, où la distance entre chaque première puce de LED (214) et chaque premier axe central (252), est modifiée selon la position de chaque première structure de boîtier de LED (212) sur le substrat (204), et la distance entre chaque seconde puce de LED (232) et chaque second axe central (256), est modifiée selon la position de chaque seconde structure de boîtier de LED (230) sur le substrat (204).

3. Dispositif d'affichage stéréoscopique à LED selon la revendication 1, où chaque premier élément optique est une première lentille (218), chaque première lentille (218) comprend une pluralité de premières surfaces incurvées (2201, 2202, 2203, 2204, et 2205), chaque second élément optique est une seconde lentille (236), chaque seconde lentille (236) comprend une pluralité de secondes surfaces incurvées (2381, 2382, 2383, 2384, et 2385), chaque première surface incurvée (2201, 2202, 2203, 2204, ou 2205) présente le premier plan d'image (2221, 2222, 2223, 2224, ou 2225) qui correspond à chaque première surface incurvée (2201, 2202, 2203, 2204, ou 2205), chaque seconde surface incurvée (2381, 2382, 2383, 2384, ou 2385) présente le second plan d'image (2401, 2402, 2403, 2404, ou 2405) qui correspond à chaque seconde surface incurvée (2381, 2382, 2383, 2384, ou 2385), les premiers faisceaux de lumière secondaire (2261, 2262, 2263, 2264, et 2265) passent respectivement à travers chaque première surface incurvée (2201, 2202, 2203, 2204, ou 2205), et sont projetés sur les premiers plans d'image (2221, 2222, 2223, 2224, et 2225) qui correspondent aux premiers faisceaux de lumière secondaire (2261, 2262, 2263, 2264, et 2265), et les seconds faisceaux de lumière secondaire (2441, 2442, 2443, 2444, et 2445) passent respectivement à travers chaque seconde surface incurvée (2381, 2382, 2383, 2384, ou 2385), et sont projetés sur les seconds plans d'image (2401, 2402, 2403, 2404, et 2405) qui correspondent aux seconds faisceaux de lumière secondaire (2441, 2442, 2443, 2444, et 2445).

4. Dispositif d'affichage stéréoscopique à LED selon la revendication 1, où chaque premier élément optique est une première barrière de parallaxe (618), chaque première barrière de parallaxe (618) comprend une pluralité de premières zones d'exposition (623, 624, 625, 626, et 627), chaque second élément optique est une seconde barrière de parallaxe (642), chaque seconde barrière de parallaxe (642) comprend une pluralité de secondes zones d'exposition (647, 648, 649, 650, et 651), chacune de la pluralité de premières zones d'exposition (623, 624, 625, 626, ou 627) présente respectivement le premier plan d'image (628, 629, 630, 631, ou 632) qui correspond à chacune de la pluralité de premières zones d'exposition (623, 624, 625, 626, ou 627), chacune de la pluralité de secondes zones d'exposition (647, 648, 649, 650, ou 651) présente respectivement le second plan d'image (652, 653, 654, 655, ou 656) qui correspond à chacune de la pluralité de secondes zones d'exposition (647, 648, 649, 650, ou 651), la pluralité de premiers faisceaux de lumière secondaire (635, 636, 637, 638, et 639) passent respectivement à travers chacune de la pluralité de premières zones d'exposition (623, 624, 625, 626, ou 627), et sont projetés sur les premiers plans d'image (628, 629, 630, 631, et 632) qui correspondent à la pluralité de premières zones d'exposition (623, 624, 625, 626, et 627), et les seconds faisceaux de lumière secondaire (659, 660, 661, 662, et 663) passent respectivement à travers chacune de la pluralité de secondes zones d'exposition (647, 648, 649, 650, ou 651) et sont projetés sur les seconds plans d'image (652, 653, 654, 655, et 656) qui correspondent à la pluralité de secondes zones d'exposition (647, 648, 649, 650, et 651).

5. Dispositif d'affichage stéréoscopique à LED selon la revendication 1, où chaque première unité de pixel (210) comprend au moins trois premières structures de boîtiers de LED (212), et chacune de la pluralité de premières structures de boîtiers de LED (212) comprend respectivement au moins une puce de LED rouge, au moins une puce de LED bleue, et au moins une puce de LED verte ; et chaque seconde unité de pixel (228) comprend au moins trois secondes structures de boîtiers de LED (230), et chacune de la pluralité de secondes structures de boîtiers de LED (230) comprend respectivement au moins une puce de LED rouge, au moins une puce de LED bleue, et au moins une puce de LED verte.

6. Dispositif d'affichage stéréoscopique à LED selon la revendication 5, où les premières structures de boîtiers de LED (212) sont agencées linéairement, et les secondes structures de boîtiers de LED (230) sont agencées linéairement.

7. Dispositif d'affichage stéréoscopique à LED selon la revendication 1, où le substrat (204) comprend une première zone (82), une deuxième zone (84), et une troisième zone (86), un premier angle inclus (X₁) est formé entre la première zone (82) et la deuxième zone (84), un second angle inclus (X₂) est formé entre la deuxième zone (84) et la troisième zone (86), la première zone (82) comprend un premier axe central (90), la deuxième zone (84) comprend un deuxième axe central (92), la troisième zone (86) comprend un troisième axe central (94), le premier angle inclus et le second angle inclus permettent au premier axe central (90), au deuxième axe central (92), et au troisième axe central (94) de se croiser en un point.
